(19) **Europäisches Patentamt**
**European Patent Office**
**Office européen des brevets**

(11) **EP 3 096 596 B1**

(12) **EUROPEAN PATENT SPECIFICATION**

(45) Date of publication and mention
of the grant of the patent:
**25.03.2020 Bulletin 2020/13**

(51) Int Cl.:
***H05K 13/08*** *(2006.01)*

(21) Application number: **15737258.2**

(86) International application number:
**PCT/JP2015/050265**

(22) Date of filing: **07.01.2015**

(87) International publication number:
**WO 2015/107959 (23.07.2015 Gazette 2015/29)**

(54) **QUALITY CONTROL APPARATUS, QUALITY CONTROL METHOD, AND PROGRAM**

QUALITÄTSKONTROLLVORRICHTUNG, QUALITÄTSKONTROLLVERFAHREN UND PROGRAMM

APPAREIL DE CONTRÔLE DE QUALITÉ, PROCÉDÉ DE CONTRÔLE DE QUALITÉ, ET
PROGRAMME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.01.2014 JP 2014004106**

(43) Date of publication of application:
**23.11.2016 Bulletin 2016/47**

(73) Proprietor: **Omron Corporation
Kyoto-shi, Kyoto 600-8530 (JP)**

(72) Inventors:
• **TANAKA Mayuko
Kyoto-shi
Kyoto 600-8530 (JP)**

• **FUJII Shimpei
Kyoto-shi
Kyoto 600-8530 (JP)**
• **MORI Hiroyuki
Kyoto-shi
Kyoto 600-8530 (JP)**

(74) Representative: **Kilian Kilian & Partner
Aidenbachstraße 54
81379 München (DE)**

(56) References cited:
**JP-A- H0 486 548          JP-A- 2006 237 236
JP-A- 2010 271 165      JP-A- 2011 018 696
JP-A- 2012 145 483      US-A- 5 560 533
US-A1- 2008 166 039**

**Description**

TECHNICAL FIELD

The present invention relates to a technology of inspecting and managing a surface mounting line.

BACKGROUND ART

Mounting of a printed circuit board is dramatically improved by a Surface Mount Technology (SMT) of directly soldering an electronic component such as a chip component on a surface of the printed circuit board and miniaturization of the electronic component. In the surface mount technology, screen printing of solder paste (solder paste) is performed on an electrode portion (land) of the printed circuit board, the electronic component is loaded on the printed circuit board with a mounter, the printed circuit board is heated in a high-temperature furnace generally called a reflow furnace, and the solder paste is welded to solder the electronic component onto the surface of the printed circuit board.

An inspection is performed in each process in order to detect an abnormality in the process of a surface mounting line. Patent Document 1 discloses a technology in which teaching data, such as a solder area, which should be determined to be nondefective in the solder printing inspection, is automatically changed from a measured value such as the solder area in the solder printing inspection and from defective or nondefective of a post-reflow inspection. In Patent Document 1, an inspection parameter is properly adjusted in a preceding process, and only the case leading to a post-reflow defect can be determined to be defective in the preceding process.

PRIOR ART DOCUMENT

PATENT DOCUMENT

Patent Document 1: Japanese Unexamined Patent Publication No. 2007-43009

A further prior art document is US 2008/166039 A1 which discloses a process control method that is provided for a surface mount line including a solder printer for printing solder on a surface of a substrate, a solder print inspector for inspecting the printed solder and outputting printing quality data, a mounter for mounting components on the substrate with the solder printed, a mount inspector for inspecting a state of the mounted components and outputting mounting quality data, a reflow furnace for heating the solder to solder the components to the substrate, and a soldering inspector for inspecting a state of the soldering and outputting soldering pass/fail data. The process control method includes: retrieving the printing quality data, the mounting quality data, and the soldering pass/fail data from a primary recorder with the printing quality data, the mounting quality data, and the soldering pass/fail data recorded therein, calculating representative data for each said component from the printing quality data, and recording the representative data, the mounting quality data, and the soldering pass/fail data for each said component in a secondary recorder; and determining whether the solder printer and the mounter need adjustment by using the data of the components with the soldering pass/fail data indicating conforming among the data recorded in the secondary recorder.

Moreover, a further prior art document is US 5 560 533 A which discloses a mounted circuit board producing system which includes a plurality of mounted circuit board production lines having a solder printing unit, a component mounting unit, and a soldering unit. The system includes an inspection device for inspecting at least one equipment at the solder printing unit, component mounting unit, and soldering unit and given monitor items with respect to circuit boards to be mounted, a data analyzing part for analyzing, according to a warning criterion applicable prior to a predetermined defective judgement criterion being reached, qualitative conditions of both the equipment and individual circuit boards from results of inspections made by the inspection device, and a control device for controlling, on the basis of analysis results at the data analyzing part, at least one of the solder printing unit, component mounting unit, and soldering unit for a change of operating conditions over the entire production line.

SUMMARY OF THE INVENTION

PROBLEMS TO BE SOLVED BY THE INVENTION

Because the technology described in Patent Document 1 is aimed at a determination of nondefective or defective, in variation factors of preceding processes such as a solder printing process and a mount process, a defect that is not determined to be defective (not satisfying a quality standard) after a reflow process can hardly be detected. That is, the determination of the defect is not made by a preceding process inspection until the defect is generated after the reflow process. In Patent Document 1, a factor of the defect is hardly identified in the case that the defect is generated.

In the surface mounting line, it is preferable that an event (defect predictor) possibly developed to the defect is detected before the defect is generated, and that a mounting condition is corrected such that a generation factor of the event is removed. However, the defect predictor can hardly be detected by the technique of Patent Document 1. Additionally, it is unclear which one of setting parameters in the preceding process is corrected even after the generation of the defect.

An object of the present invention is to provide a technology of identifying the variation factor leading to the defect in the solder printing process and component mounting process and of correcting the setting parameter in the solder printing process or mount process on the basis of the post-reflow inspection. This object is achieved by the subject matter of the independent claims. Further advantageous embodiments of the invention are the subject matter of the dependent claims. Aspects of the invention are set out below.

In the present invention, the defect predictor is detected on the basis of the post-reflow inspection result and, when the defect predictor is detected, the setting parameter in the solder printing process or component mounting process is changed such that the factor of the defect predictor is corrected. Specifically, when nonuniformity of an inspection item (feature amount) in which different portions should be identical to each other is greater than or equal to a predetermined value with respect to a post-reflow mounting board, a determination that the defect predictor is generated is made, and the setting parameter in the solder printing process or component mounting process is changed according to the inspection item.

More particularly, according to a further aspect of the present invention, a quality control apparatus configured to manage a surface mounting line in which a solder printing process, a mount process, and a reflow process are performed, solder being printed onto a printed circuit board with a solder printing apparatus in the solder printing process, an electronic component being disposed on the printed circuit board with a mounter in the mount process, the electronic component being soldered with a reflow furnace in the reflow process, the quality control apparatus includes: a nonuniformity calculating unit configured to calculate nonuniformity of a feature amount associated with a position or a shape in which plural different portions of the electronic component or a bonded location between the electronic component and the printed circuit board should be identical to each other; a determination unit configured to determine whether the nonuniformity is greater than or equal to a predetermined threshold; and a parameter changing unit configured to change a setting parameter of the solder printing apparatus or the mounter or to propose the change in setting parameter, when the nonuniformity is greater than or equal to the predetermined threshold.

In the configuration, the defect predictor is detected from the post-reflow inspection, a factor (defect predictor factor) causing the defect predictor in the solder printing process or mount process is identified, and the setting parameter of the solder printing apparatus or mounter can be changed. In the solder printing apparatus or mounter, various variation factors such as deterioration with time and an environmental change can become the defect predictor factor. Because the setting parameter of the solder printing apparatus or mounter is changed on the basis of the post-reflow inspection, the defect predictor factor that is hardly identified by the solder printing inspection or mount inspection can be identified and corrected. The factor leading to the defect in the variation factors in the solder printing process or mount process is detected before the actual generation of the defect, and the setting parameter is changed such that the variation factor is removed. Therefore, the generation of the defect can be prevented before it happens, and a possibility of stopping a production line can be minimized.

The nonuniformity is calculated based on a difference or a ratio between a maximum value and a minimum value of each of the plural feature amounts in the different portions of the mounting board. The maximum value or the minimum value may be obtained as the maximum or minimum feature amount. Alternatively, an average value of the feature amounts is calculated in each group (for example, portions arrayed in line as a group), and the maximum value or the minimum value may be obtained as a maximum value or a minimum value of the average value. The difference or the ratio between the maximum value and the minimum value may be normalized using another measured value (for example, a component thickness in the case that the nonuniformity of a component height is calculated). A statistic, such as a variance, which expresses a variation such as variance may be calculated as the nonuniformity in addition to the difference and the ratio.

Preferably, the nonuniformity calculating unit calculates the nonuniformity with respect to plural kinds of the feature amounts. The determination unit has a different threshold in each kind of the feature amount, and makes a determination of each kind of the feature amount. Preferably the parameter changing unit issues an instruction, when the nonuniformity of at least one of the plural kinds of the feature amounts is greater than or equal to a predetermined threshold, the setting parameter to be changed according to the kind of the feature amount with the nonuniformity greater than or equal to the predetermined threshold, to the solder printing apparatus or mounter. Therefore, the parameter changing unit may store a setting parameter item to be changed and how to change the setting parameter item while correlating the setting parameter item to be changed and how to change the setting parameter item with the plural kinds of the feature amounts. A location where the feature amount is calculated may vary in each of the plural kinds of the feature amounts.

In the configuration, the defect predictor factor in the solder printing process or mount process can be identified with respect to the plural post-reflow inspection items, and the setting parameter can be corrected.

In the quality control apparatus, preferably the parameter changing unit presents the kind of the feature amount with the nonuniformity greater than or equal to the predetermined threshold, the nonuniformity of the corresponding feature amount, and the setting parameter of a change target to a user, when changing the setting parameter or when proposing the change of the setting parameter to the user. This is because a user can easily recognize which one of defect predictive event happens and which one of setting parameters is changed.

In the quality control apparatus, preferably the parameter changing unit proposes the change of the setting parameter to the user and asks the user whether the change of the setting parameter is permitted, and the parameter changing unit changes the setting parameter when receiving an input to permit the change from the user. This is because the setting parameter is changed after a user's check.

A solder printing position, a solder amount, a printing pressure, and a printing speed of the solder printing apparatus and a component suction position, a component loading position, a pushing amount, and a loading speed of the mounter can be cited as an example of the setting parameter to be changed.

A height position of an electrode top of the electronic component can be adopted as the feature amount, and a component suction position of the mounter can be adopted as the setting parameter to be changed. When a suction position of a suction nozzle of the mounter deviates from an original position, an opposite side to a deviation direction is lowered by a dead weight, and sometimes the electronic component is obliquely mounted. Accordingly, when the nonuniformity of a height of the electrode top of the electronic component is larger than a permissible range, the parameter changing unit preferably changes the setting parameter such that the component suction position of the mounter is moved in a direction toward a portion giving a minimum value of the height of the electrode top.

A height position of an edge of the electronic component can be adopted as the feature amount, and a component suction position of the mounter can be adopted as the setting parameter to be changed. When a suction position of a suction nozzle of the mounter deviates from an original position, an opposite side to a deviation direction is lowered by a dead weight, and sometimes the electronic component is obliquely mounted. Accordingly, when the nonuniformity of a height of the edge of the electronic component is larger than a permissible range, the parameter changing unit preferably changes the setting parameter such that the component suction position of the mounter is moved in a direction toward a portion giving a minimum value of the height of the edge.

A height position of an electrode bottom of the electronic component can be adopted as the feature amount, and a component suction position of the mounter can be adopted as the setting parameter to be changed. When the suction position of a suction nozzle of the mounter deviates from an original position, an opposite side to a deviation direction is lowered by a dead weight, and sometimes the electronic component is obliquely mounted. Accordingly, when the nonuniformity of a height of the electrode bottom of the electronic component is larger than a permissible range, the parameter changing unit preferably changes the setting parameter such that the component suction position of the mounter is moved in a direction toward a portion giving a minimum value of the height of the electrode bottom.

A land length that does not overlap the electronic component (referred to as a land projection amount) can be adopted as the feature amount, and a component loading position of the mounter can be adopted as the setting parameter to be changed. When the position where the electronic component is loaded with the mounter deviates from an original position, the land projection amount decreases in the deviation direction. Accordingly, when the nonuniformity of the land projection amount is larger than a permissible range, the parameter changing unit preferably changes the setting parameter such that the component loading position of the mounter is moved in a direction toward a portion giving a maximum value of the land projection amount.

A wetting-up height position of solder relative to an electrode of the electronic component can be adopted as the feature amount, and a component loading position of the mounter can be adopted as the setting parameter to be changed. When the position where the electronic component is loaded with the mounter deviates from the original position, the wetting-up height of the solder increases because the amount of solder that is in contact with the electrode increases in the deviation direction. Accordingly, when the nonuniformity of the wetting-up height of the solder relative to an electrode of the electronic component is larger than a permissible range, the parameter changing unit preferably changes the setting parameter such that the component loading position of the mounter is moved in a direction toward a portion giving a minimum value of the wetting-up height.

A solder length on a land length that does not overlap the electronic component (referred to as a land wet length) can be adopted as the feature amount, and a component loading position of the mounter can be adopted as the setting parameter to be changed. When the position where the electronic component is loaded with the mounter deviates from the original position, the land wet length decreases in the deviation direction. Accordingly, when the nonuniformity of the land wet length is larger than a permissible range, the parameter changing unit preferably changes the setting parameter such that the component loading position of the mounter is moved in a direction toward a portion giving a maximum value of the land wet length.

A wet angle on a land side of solder bonding the electronic component can be adopted as the feature amount, and a component loading position of the mounter can be adopted as the setting parameter to be changed. When the position where the electronic component is loaded with the mounter deviates from the original position, the wet angle on the land side decreases in the deviation direction. Accordingly, when the nonuniformity of the wet angle on the land side of the solder is larger than a permissible range, the parameter changing unit preferably changes the setting parameter such that the component loading position of the mounter is moved in a direction toward a portion giving a maximum value of the wet angle on the land side.

A wet angle on an electrode side of solder bonding the electronic component can be adopted as the feature amount, and a component loading position of the mounter can be adopted as the setting parameter to be changed. When the position where the electronic component is loaded with the mounter deviates from the original position, the wet angle on the electrode side decreases in the deviation direction. Accordingly, when the nonuniformity of the wet angle on the electrode side of the solder is larger than a permissible range, the parameter changing unit preferably changes the setting parameter such that the component loading position of the mounter is moved in a direction toward a portion giving a maximum value of the wet angle on the electrode side.

A length of a back fillet of solder bonding the electronic component can be adopted as the feature amount, and a component loading position of the mounter can be adopted as the setting parameter to be changed. When the position where the electronic component is loaded with the mounter deviates from the original position, the back fillet length increases in the deviation direction. Accordingly, when the nonuniformity of the back fillet length is larger than a permissible range, the parameter changing unit preferably changes the setting parameter such that the component loading position of the mounter is moved in a direction toward a portion giving a minimum value of the back fillet length.

As to the movement direction of the component suction position or component loading position of the mounter, the term "the direction toward the portion giving the minimum value (maximum value) of the feature amount" may be "the direction from the portion giving the maximum value (minimum value) of the feature amount toward the portion giving the minimum value (maximum value)" or the direction decided on the basis of "the direction from the portion giving the maximum value (minimum value) of the feature amount toward the portion giving the minimum value (maximum value)" in predetermined directions (for example, four directions orthogonal to one another). For example, "the direction from the portion giving the maximum value (minimum value) of the feature amount toward the portion giving the minimum value (maximum value)" in the predetermined directions may be set to the movement direction. Alternatively, in the case that electrodes are provided in line at an end of the component, "the direction from the portion giving the maximum value (minimum value) of the feature amount toward the portion giving the minimum value (maximum value)" and the direction perpendicular to the line may be set to the movement direction.

The present invention can be comprehended as a quality control apparatus including at least a part of the units. The present invention can be comprehended as a surface mounting inspection management system including the quality control apparatus and a production management apparatus that controls a solder printing apparatus and mounter. The present invention can also be comprehended as a quality control method including at least a part of the above pieces of processing, a computer program causing a computer to execute the quality control method, or a computer-readable recording medium in which the computer program is recorded. The present invention can be made by combining the configurations and functions as long as a technical inconsistency is not generated.

EFFECT OF THE INVENTION

In the present invention, on the basis of the post-reflow inspection, the variation factor leading to the defect can be identified in the solder printing process and component mounting process, and the setting parameter can be corrected in the solder printing process or mount process.

BRIEF DESCRIPTION OF THE DRAWINGS

Fig. 1 is a view illustrating a configuration outline of production facilities and quality control system in a surface mounting line.
Fig. 2 is a functional block diagram of an inspection management system according to an embodiment.
Fig. 3 is a view illustrating an example of a nonuniformity and mounting condition corresponding table in a first embodiment.
Fig. 4 is a flowchart illustrating a processing flow of the inspection management system of the embodiment.
Fig. 5 is a view illustrating an electrode top height imbalance.
Fig. 6 is a view illustrating a component body edge height imbalance.
Fig. 7 is a view illustrating an electrode bottom height imbalance.
Fig. 8 is a view illustrating a land projection amount imbalance.
Fig. 9 is a view illustrating an electrode wetting-up height imbalance.
Fig. 10 is a view illustrating a land wet length imbalance.

Fig. 11 is a view illustrating a land wet angle imbalance.
Fig. 12 is a view illustrating an electrode wet angle imbalance.
Fig. 13 is a view illustrating a back fillet length imbalance.
Fig. 14 is a view illustrating an imbalance caused by a printing misalignment.
Fig. 15 is a view illustrating an example of a nonuniformity and mounting condition correspondence table in a second embodiment.

MODES FOR CARRYING OUT THE INVENTION

Hereinafter, an exemplary embodiment of the present invention will be described in detail with reference to the drawings. However, the present invention is not limited to a size, a material, a shape, and a relative disposition of a component described in the embodiment unless otherwise noted.

(First embodiment)

<System configuration>

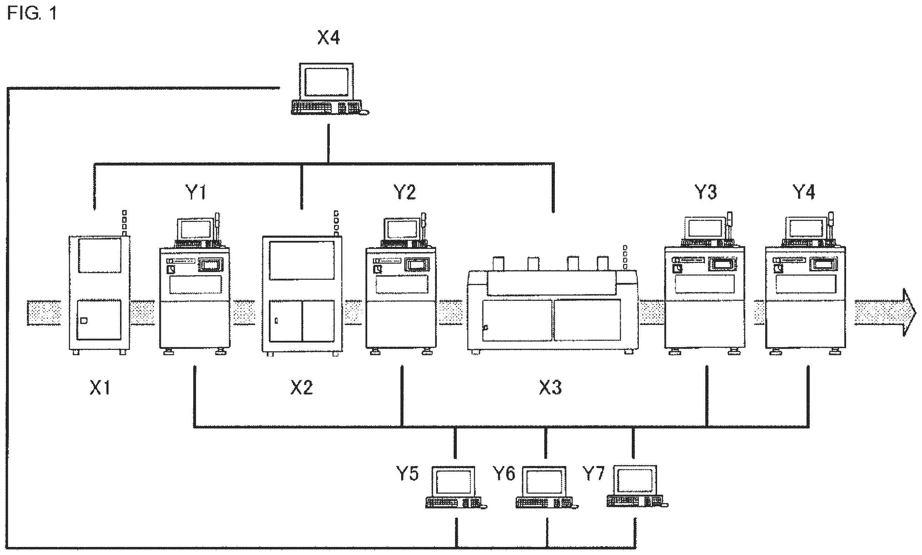

Fig. 1 schematically illustrates configuration example of production facilities and a quality control system in a surface mounting line of a printed circuit board. A Surface Mount Technology (SMT) is a technology of soldering the electronic component on the surface of the printed circuit board, and the surface mounting line is mainly constructed with three processes, namely, solder printing, component mount, and reflow (welding of solder).

As illustrated in Fig. 1, in the surface mounting line, a solder printing apparatus X1, a mounter X2, and a reflow furnace X3 are sequentially provided from an upstream side as the production facilities. The solder printing apparatus X1 is an apparatus that prints the solder paste onto an electrode portion (called a land) on a printed circuit board by the screen printing. The mounter X2 is an apparatus that picks up the electronic component to be mounted on the board and places the component on the solder paste at the corresponding point, and the mounter X2 is also called a chip mounter. The reflow furnace X3 is a heating apparatus that heats and melts the solder paste, and cools the solder paste to bond the electronic component onto the board. The production facilities X1 to X3 are connected to a production facility management apparatus X4 through a network (LAN). The production facility management apparatus X4 is a system that manages and wholly controls the production facilities X1 to X3. The production facility management apparatus X4 includes functions of storing, managing, and outputting a mounting program (including an operation procedure, a production condition, and a setting parameter) defining an operation of each production facility and log data of each production facility. The production facility management apparatus X4 also includes a function of updating the mounting program set to the corresponding production facility when an instruction to change the mounting program is received from an operator or another apparatus.

A quality control system Y is installed in the surface mounting line. The quality control system Y inspects a state of the board at an exit of each of the processes of the solder printing, the component mount, and the reflow, and automatically detects the defect or a risk of the defect. In addition to a function of automatically sorting the nondefective and defective, the quality control system Y has a function (for example, the change of the mounting program) of performing feedback to the operation of each production facility on the basis of the inspection result or an analysis result of the inspection result. As illustrated in Fig. 1, the quality control system Y of the first embodiment includes four kinds of inspection apparatuses, an inspection management apparatus Y5, an analyzer Y6, and a workstation Y7. The four kinds of inspection apparatuses includes a solder printing inspection apparatus Y1, a component inspection apparatus Y2, an appearance inspection apparatus Y3, and an X-ray inspection apparatus Y4.

The solder printing inspection apparatus Y1 is an apparatus that inspects the state of the solder paste printed on the board carried out from the solder printing apparatus X1. In the solder printing inspection apparatus Y1, the solder paste printed on the board is two-dimensionally or three-dimensionally measured, whether each kind of an inspection item is a normal value (permissible range) is determined from a measurement result. Examples of the inspection items include a volume, an area, a height, misregistration, and a shape of the solder. An image sensor (camera) can be used in the two-dimensional measurement of the solder paste, and a laser displacement meter, a phase shift method, a spatial coding method, and a photo cutting method can be adopted in the three-dimensional measurement.

The component inspection apparatus Y2 is an apparatus that inspects a disposition state of the electronic component with respect to the board carried out from the mounter X2. In the component inspection apparatus Y2, the component (component body or such a part of the component as an electrode (lead)) placed on the solder paste is two-dimensionally or three-dimensionally measured, whether each kind of the inspection item is the normal value (permissible range) is determined from the measurement result. Examples of the inspection items include the misregistration and angle (rotation) deviation of the component, shortage (the component is not disposed), a wrong component (a wrong component is disposed), wrong polarity (the component side and the board side differ from each other in an electrode

6

polarity), reversal (the component is reversely disposed), and a component height. Similarly to the solder printing inspection, the image sensor (camera) can be used in the two-dimensional measurement of the electronic component, and the laser displacement meter, the phase shift method, the spatial coding method, and the photo cutting method can be adopted in the three-dimensional measurement.

The appearance inspection apparatus Y3 is an apparatus that inspects a soldering state of the board carried out from the reflow furnace X3. In the appearance inspection apparatus Y3, the post-reflow soldered portion is two-dimensionally or three-dimensionally measured, whether each kind of the inspection item is a normal value (permissible range) is determined from a measurement result. In addition to the same inspection items as the component inspection, the nondefective of defective of a solder fillet shape is also included in the inspection item. What is called a color highlight method (a soldering surface is irradiated with R, G, and B illuminations at different incident angles, and reflected light of each color is photographed with a zenith camera, whereby the three-dimensional shape of the solder is detected as two-dimensional hue information) can be adopted as the measurement of the solder shape in addition to the laser displacement meter, the phase shift method, the spatial coding method, and the photo cutting method.

The X-ray inspection apparatus Y4 is an apparatus that inspects the soldered state of the board using an X-ray image. For a package component such as a BGA (Ball Grid Array) and a CSP (Chip Size Package) or a multilayer board, because the solder bonding portion is hidden behind the component or board, the appearance inspection apparatus Y3 can hardly inspect the soldered state (that is, the soldered state is hardly inspected in the appearance image). The X-ray inspection apparatus Y4 is an apparatus that complements a weak point of the appearance inspection. Examples of the inspection items of the X-ray inspection apparatus Y4 include the misregistration of the component, the solder height, the solder volume, a diameter of a solder ball, the back fillet length, and the nondefective and defective of the solder bonding. An X-ray transmission image may be adopted as the X-ray image, or preferably a CT (Computed Tomography) image is also used.

The inspection apparatuses Y1 to Y4 are connected to the inspection management apparatus Y5 through the network (LAN). The inspection management apparatus Y5 is a system that manages and wholly controls the inspection apparatuses Y1 to Y4. The inspection management apparatus Y5 includes functions of storing, managing, and outputting an inspection program (including an operation procedure, an inspection condition, and a setting parameter) defining operations of the inspection apparatuses Y1 to Y4 and the inspection results or pieces of log data obtained with the inspection apparatuses Y1 to Y4.

The analyzer Y6 is a system that includes a function of performing prediction or factor estimation of the defect by analyzing the inspection results (the inspection results of the processes) of the inspection apparatuses Y1 to Y4, the inspection results of the inspection apparatuses Y1 to Y4 being aggregated into the inspection management apparatus Y5, and a function of performing the feedback (such as the change of the mounting program) to each of the production facilities X1 to X3 as needed basis.

The workstation Y7 is a system that includes a function of displaying pieces of information about the states of the production facilities X1 to X3, the inspection results of the inspection apparatuses Y1 to Y4, and the analysis result of the analyzer Y6, a function of changing (editing) the mounting program and inspection program of the production facility management apparatus X5 and inspection management apparatus Y5, and a function of checking an operating situation of the whole surface mounting line.

Each of the production facility management apparatus X4, the inspection management apparatus Y5, and the analyzer Y6 can be constructed with a general-purpose computer system including a CPU (Central Processing Unit), a main storage device (memory), an auxiliary storage device (such as a hard disk), an input device (such as a keyboard, a mouse, a controller, and a touch panel), and a display. The apparatuses X4, Y5, and Y6 can be separately provided, all the functions of the apparatuses X4, Y5, and Y6 can be implemented in one computer system, or a part of or all the functions of the apparatuses X4, Y5, and Y6 can be implemented in a computer included in one of the production facilities X1 to X3 and the inspection apparatuses Y1 to Y4. Although the networks of the production facilities and quality control system are individually illustrated in Fig. 1, a network having any configuration can be used as long as data communication can be conducted between the production facilities and the quality control system.

<Quality control system>

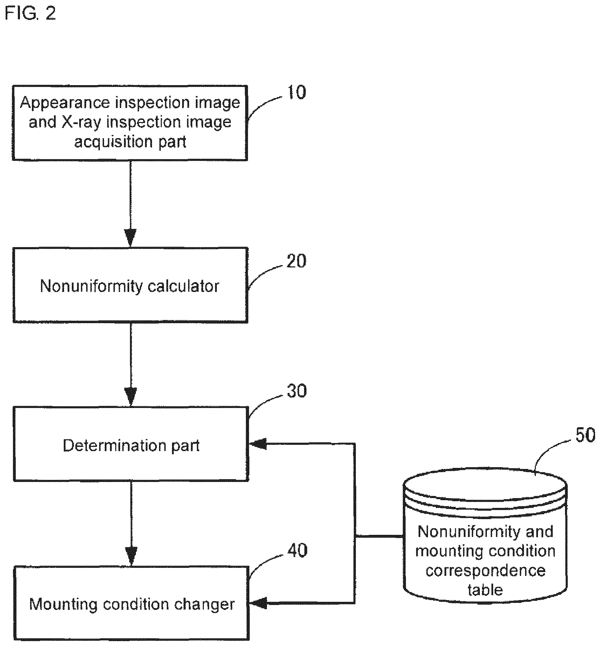

The quality control system of the first embodiment will be described in detail. The quality control system measures the solder shape from the post-reflow mounting board, detects the defect predictor of the mounter X2 on the basis of the measurement result, and issues an instruction to change the setting parameter (mounting condition) of the mounter X2 through the production facility management apparatus X4. Fig. 2 is a functional block diagram of the quality control system of the first embodiment. The computer of the analyzer Y6 executes the program to implement the functional blocks in Fig. 2. Alternatively, other apparatuses of the quality control system Y may implement the functions in conjunction with one another. Only the functional blocks implementing the functions are illustrated in Fig. 2, and other functions of performing the quality control of the surface mounting line are omitted.

An appearance inspection image and X-ray image acquisition part 10 (hereinafter, also simply referred to as an image acquisition part 10) is a functional part that acquires the appearance image photographed with the appearance inspection apparatus Y3 and the X-ray image photographed with the X-ray inspection apparatus Y4.

A nonuniformity calculator 20 is a functional part that calculates the nonuniformity of each of the plural inspection items from the appearance image or X-ray image acquired with the image acquisition part 10. The nonuniformity calculator 20 calculates the nonuniformity (degree of imbalance) of the feature amount associated with the position or shape, in which different portions of the post-reflow mounting board should be identical to each other when being in the normal state. In the case that plural components having the identical shape exist in the electronic component or the bonding portion (including the solder paste and the land) between electronic component and the printed circuit board, sometimes the nonuniformity is caused by the variation factor on the surface mounting line although the different portions of the post-reflow mounting board should be identical to each other in the position or the shape. Although described in detail later, for example, the different portions of the post-reflow mounting board should originally be identical to each other in the height position of an electrode top of the electronic component. However, the height position varies depending on the variation factor. Accordingly, the nonuniformity calculator 20 obtains the height position of the electrode top of the electronic component with respect to plural different portions, and calculates the difference or ratio between the maximum value and the minimum value as the nonuniformity of the feature amount. The nonuniformity calculator 20 calculates the nonuniformity with respect to each of the plural inspection items (to be described later).

In addition to the difference or ratio between the maximum value and the minimum value in the plural different portions, the nonuniformity of the feature amount may be a value in which the difference or ratio is normalized using other feature amounts (such as an electrode thickness and an electrode tip interval) of the electronic component. Alternatively, a variance or a standard deviation of the feature amount in the plural different portions may be adopted as the nonuniformity. A specific method for calculating the nonuniformity in each inspection item is described later.

At this point, it is assumed that the nonuniformity calculator 20 calculates the feature amount from the appearance image or X-ray image to calculate the nonuniformity. Alternatively, the nonuniformity calculating method can arbitrarily be modified when the analyzer Y6 acquires the nonuniformity. For example, the inspection management apparatus Y5, the appearance inspection apparatus Y3, or the X-ray inspection apparatus Y4 calculates the feature amount and the nonuniformity, and the analyzer Y6 may acquire the calculated nonuniformity. Alternatively, the inspection management apparatus Y5, the appearance inspection apparatus Y3, or the X-ray inspection apparatus Y4 calculates the feature amount, and the analyzer Y6 may calculate the nonuniformity from the feature amount.

A determination part 30 is a functional part that determines whether the nonuniformity calculated with the nonuniformity calculator 20 falls within the permissible range. "The permissible range" of the nonuniformity is used to detect the event that becomes the defect predictor in a product, and is different from a quality standard used in the determination of the nondefective and defective product. That is, even if the nonuniformity is out of the permissible range, the product is not always determined to be defective. The event (defect predictive event) that becomes the defect predictor is an event that has a high probability of generating the defect when event is left as it is. A threshold of the permissible range is previously stored in a nonuniformity and mounting condition correspondence table 50 (hereinafter, also simply referred to as a table 50), and the nonuniformity calculator 20 acquires the threshold of the permissible range in each inspection item, and determines whether the measured value is greater than or equal to the threshold.

A mounting condition changer 40 is a functional part that issues an instruction to the production facility management apparatus X4 to change the mounting condition of the mounter X2 when the determination part 30 determines that the nonuniformity exceeds the permissible range. In the case that the nonuniformity is out of the permissible range, how to correct the mounting condition is stored in the table 50 with respect to each inspection item. The mounting condition changer 40 refers to the table 50 with respect to the inspection item, which has the nonuniformity exceeding the permissible range, decides how to correct the mounting condition, and issues the instruction to the production facility management apparatus X4. The instruction to change the mounting condition of the mounter X2 may immediately be issued when the nonuniformity exceeds the permissible range, or the mounting condition may be changed when the nonuniformity exceeds the permissible range at a predetermined frequency or more.

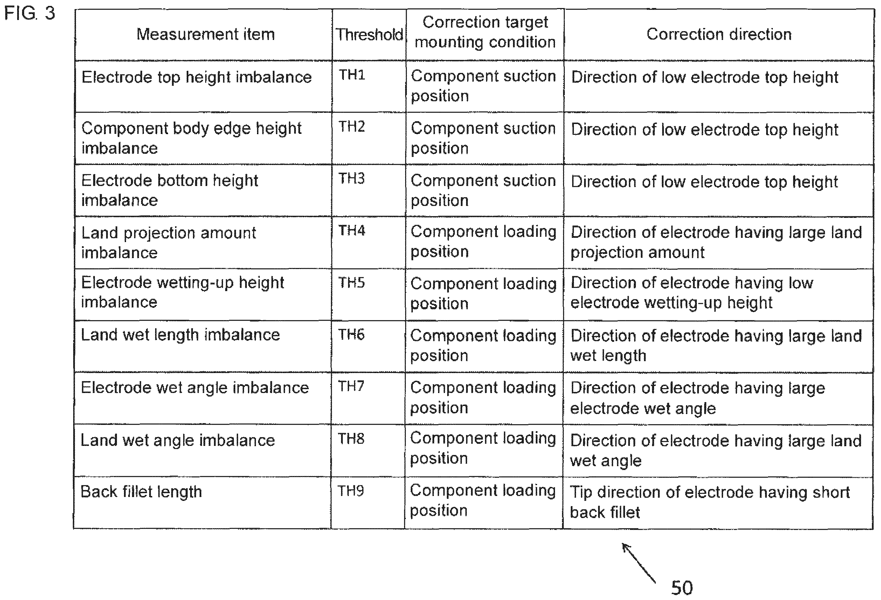

The nonuniformity and mounting condition correspondence table 50 is a table in which the threshold expressing the permissible range of the nonuniformity, the mounting condition that is corrected when the nonuniformity is out of the permissible range, and how to correct the mounting condition are stored every inspection item. Fig. 3 illustrates an example of the table 50. At this point, because the mounting condition of the mounter is corrected on the basis of the appearance inspection or the X-ray inspection, the threshold defining the permissible range and how to correct the mounting condition of the mounter in the case that the nonuniformity is out of the permissible range are stored every inspection item.

In the mounting conditions of the mounter X2 of the correction target in Fig. 3, "the component suction position" is a parameter that decides the position of the suction nozzle when the component is taken out from a reel using the suction nozzle. On the other hand, "the component loading position" is a parameter that decides the position of the suction nozzle when the component taken out using the suction nozzle is disposed on the printed circuit board.

Using the table 50, the inspection item and the mounting condition of the mounter (in this case, the component suction position and the component loading position), which should be changed in the case that the nonuniformity of the inspection item is out of the permissible range, are stored while correlated with each other. Therefore, the proper mounting condition of the mounter X2 can be obtained on the basis of the result (defect predictive event) of the post-reflow appearance inspection or X-ray inspection.

<Inspection processing flow>

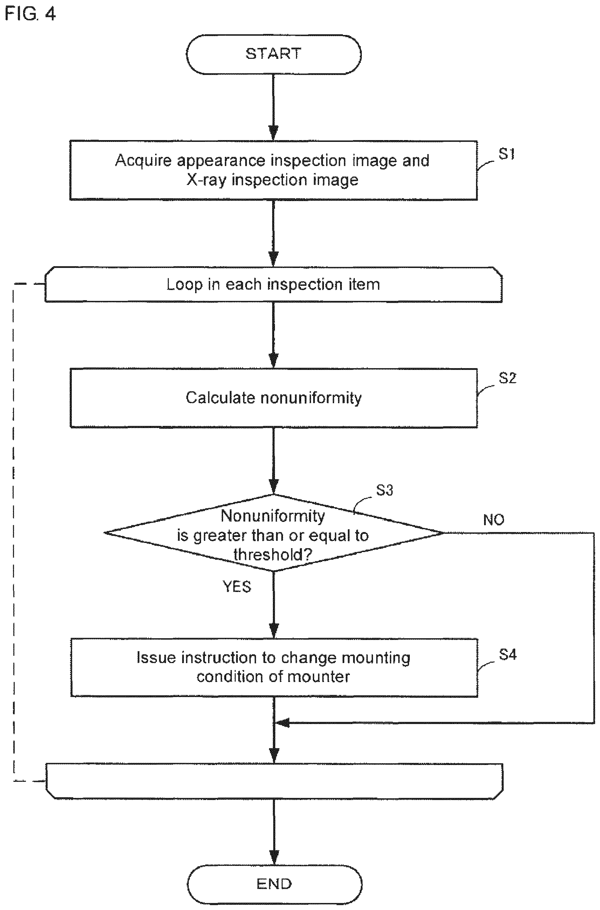

Fig. 4 is a flowchart illustrating a processing flow of the quality control system of the first embodiment. The image acquisition part 10 acquires the appearance inspection image of the appearance inspection apparatus Y3 or the X-ray inspection image of the X-ray inspection apparatus Y4 (S1). The nonuniformity calculator 20 calculates the nonuniformity of the inspection item illustrated in table 50 (Fig. 3) from the appearance inspection image or X-ray inspection image (S2). Although described in detail later, the feature amount of the inspection item is obtained with respect to plural locations of the mounting board, and the nonuniformity is calculated from the difference between the maximum value and minimum value of the feature amount. The determination part 30 compares the calculated nonuniformity to the threshold, which is stored in the table 50 while correlated with the inspection item (S3). When the nonuniformity is smaller than the threshold (NO in S3), the nonuniformity is determined to be normal, but particular processing is not performed. On the other hand, when the nonuniformity is greater than or equal to the threshold (YES in S3), the mounting condition changer 40 refers to the table 50, and transmit the instruction to the production facility management apparatus X4 such that the mounting condition of the mounter X2 is changed according to the inspection item (S4). Because how to correct the mounting condition of the mounter X2 is stored in the table 50 according to the inspection item, the mounting condition changer 40 refers to the table 50 to decide the mounting condition changing method.

In the flowchart of Fig. 4, the pieces of processing in Steps S2 to S4 are performed on each of the plural inspection items. In Fig. 4, the pieces of processing in Steps S2 to S4 are individually performed every inspection item. Alternatively, the pieces of processing in Steps S2 to S4 may be performed in parallel on each inspection item, or the pieces of processing in Steps S3 and S4 may be performed after the processing in Step S2 is performed on each inspection item.

<Detailed inspection item>

Each inspection item that becomes the inspection target in the quality control system of the first embodiment will be described in detail below. In the quality control system, it is not necessary to inspect all the following inspection items as a target to be inspected, but only a part of the inspection items may be inspected.

(1. Electrode top height imbalance)

In the case that the electrode top of the electronic component is horizontal while horizontally disposed in and soldered to the printed circuit board, an electrode top height of the electronic component should originally be uniform. Accordingly, the electrode top height is calculated as the feature amount, and the nonuniformity of the height can be set to the inspection item.

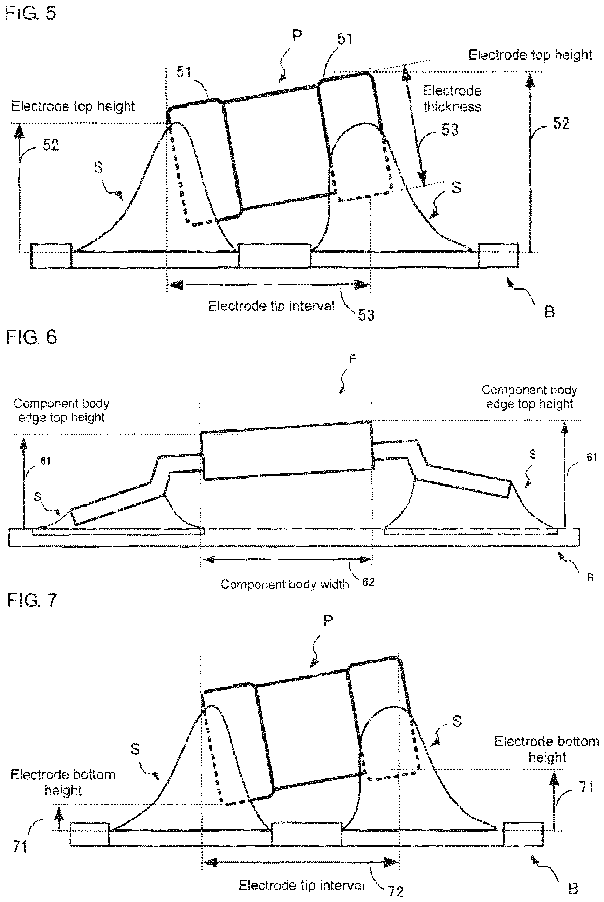

Fig. 5 is a view illustrating an electrode top height imbalance calculating method. Fig. 5 illustrates the case that an electronic component P of the chip component is soldered while obliquely disposed on the printed circuit board B. Because the electronic component P is obliquely disposed, a top height 52 of an electrode 51 of the electronic component P varies depending on the location. In the case that the electrode top height imbalance is calculated, the nonuniformity calculator 20 obtains the height in the plural different portions of the electrode top using the result of the appearance inspection or X-ray inspection. The number of locations where the height is calculated may be two or more, and specifically the number of locations may be decided in consideration of necessary conditions of detection accuracy and processing time of the defect predictor.

Preferably the height of an end portion (an end farther away from the electronic component body) of the electrode is calculated as the electrode top height as illustrated in Fig. 5, or the heights of other portions of the electrode top may be calculated.

On the basis of the obtained electrode top height, an electrode top height imbalance U1 can be obtained using the following equation.

$$U1 = \text{Max (electrode top height)} - \text{Min (electrode top height)}$$

Where Max and Min are the maximum value and the minimum value of the measured value in a parenthesis in the plural different portions of the identical electronic component, respectively. For example, in calculating the maximum value or the minimum value, an average value of the feature amounts is obtained every electrode group, and the maximum value or minimum value of the average values may be adopted. At this point, it is conceivable that the average value of the feature amounts is obtained with a group of electrodes arrayed in line as a group. Therefore, a singular value can be prevented from being set to the maximum value or the minimum value, and the maximum value or the minimum value can be taken as a tendency of the whole line.

The electrode top height imbalance U1 may be obtained according to another calculation formula as long as the calculation formula can express the nonuniformity of the electrode top height. For example, using a size (for example, the electrode thickness 53 or the electrode tip interval 54 as illustrated in Fig. 5) of the electronic component, the electrode top height imbalance may be normalized as follows.

$$U1 = (Max\ (electrode\ top\ height) - Min\ (electrode\ top\ height)) / (electrode\ thickness)$$

$$U1 = (Max\ (electrode\ top\ height) - Min\ (electrode\ top\ height)) / (electrode\ tip\ interval)$$

In this case, the electrode thickness and the electrode tip interval may previously be stored while correlated with the component, or the electrode thickness and the electrode tip interval may be calculated from the inspection image.

The ratio between the maximum value and minimum value of the electrode top height may be adopted as the electrode top height imbalance U1.

$$U1 = Max\ (electrode\ top\ height) / Min\ (electrode\ top\ height)$$

Additionally, a statistic, such as the variance or standard deviation of the electrode top height in the plural portions, which expresses the variation of the value, may be adopted as the electrode top height imbalance U1.

That the electronic component P is obliquely disposed on the board B is attributed to the fact that the suction position of the suction nozzle of the mounter X2 varies and deviates from a center of the electronic component. Because of the deviation of the suction position from the center of the electronic component, the electronic component becomes oblique by a dead weight, the electrode top height increases in the deviation direction, and the electrode top height decreases in the opposite direction to the deviation direction. Accordingly, preferably the suction position of the suction nozzle of the mounter X2 is corrected in the direction from the location giving the maximum value of the electrode top height toward the location giving the minimum value of the electrode top height. The mounting condition of the mounter X2, which should be corrected in the case that the nonuniformity of the electrode top height is out of the permissible range, and a mounting condition correcting method are stored in the table 50 (Fig. 4). A fixed value may be adopted as a change amount of the suction position, or the change amount of the suction position may be decided according to the value of the electrode top height imbalance.

(2. Component body edge height imbalance)

In the case that the top of the electronic component is horizontal while horizontally disposed in and soldered to the printed circuit board, a top height of the electronic component body should originally be uniform. Accordingly, a component body top height is calculated as the feature amount, and the nonuniformity of the feature amount can be set to the inspection item. Particularly, the height is calculated at the edge of the component body top, and the nonuniformity of the height is preferably set to the inspection item.

Fig. 6 is a view illustrating a component body edge height imbalance calculating method. Fig. 6 illustrates the case that the electronic component P of the lead component is soldered while obliquely disposed on the printed circuit board B. Because the electronic component P is oblique, a top height 61 of the electronic component P varies depending on the location. Because the difference in height between edges of the electronic component top is maximized, preferably the nonuniformity of the edge height of the component body top is calculated as the nonuniformity of the electronic component top height. In the case that the component body edge height imbalance is calculated, the nonuniformity calculator 20 obtains the height in the plural different portions at the edge of the electronic component body using the result of the appearance inspection or X-ray inspection. The number of locations where the height is calculated may be two or more, and specifically the number of locations may be decided in consideration of necessary conditions of detection accuracy and processing time of the defect predictor.

On the basis of the obtained component body edge height, a component body edge height imbalance U2 can be obtained using the following equation.

$$U2 = Max \text{ (component body edge height)} - Min \text{ (component body edge height)}$$

The component body edge height imbalance U2 may be obtained according to another calculation formula as long as the calculation formula can express the nonuniformity of the edge height of the component body top. For example, using a size (for example, component body width 62 in Fig. 6) of the electronic component, the component body edge height imbalance may be normalized as follows.

$$U2 = (Max \text{ (component body edge height)} - Min \text{ (component body edge height)}) / \text{(component body width)}$$

In this case, the component body width may previously be stored while correlated with the component, or the component body width may be calculated from the inspection image.

The ratio between the maximum value and minimum value of the component body edge height may be adopted as the component body edge height imbalance U2.

$$U2 = Max \text{ (component body edge height)} / Min \text{ (component body edge height)}$$

Additionally, a statistic, such as the variance or standard deviation of the component body edge height in the plural portions, which expresses the variation of the value, may be adopted as the component body edge height imbalance U2.

That the electronic component P is obliquely disposed on the board B is attributed to the fact that the suction position of the suction nozzle of the mounter X2 varies and deviates from a center of the electronic component. Because of the deviation of the suction position from the center of the electronic component, the electronic component becomes oblique by the dead weight, the component body edge height increases in the deviation direction, and the component body edge height decreases in the opposite direction to the deviation direction. Accordingly, preferably the suction position of the suction nozzle of the mounter X2 is corrected in the direction from the location giving the maximum value of the component body edge height toward the location giving the minimum value of the component body edge height. The mounting condition of the mounter X2, which should be corrected in the case that the nonuniformity of the component body edge height is out of the permissible range, and a mounting condition correcting method are stored in the table 50 (Fig. 4). A fixed value may be adopted as a change amount of the suction position, or the change amount of the suction position may be decided according to the value of the component body edge height imbalance.

(3. Electrode bottom height imbalance)

In the case that the electrode bottom of the electronic component is horizontal while horizontally disposed in and soldered to the printed circuit board, an electrode bottom height of the electronic component should originally be uniform. Accordingly, an electrode bottom height 71 is calculated as the feature amount, and the nonuniformity of the electrode bottom height 71 can be set to the inspection item. The electrode bottom height imbalance is an inspection item that can suitably be adopted for the chip component.

Fig. 7 is a view illustrating an electrode bottom height imbalance calculating method. Because the electrode bottom height imbalance is similar to "1. Electrode top height imbalance" except that not the electrode top height but the bottom height 71 is adopted, the description is briefly made. Because the electrode bottom is soldered, desirably the bottom height is obtained on the basis of the X-ray image.

Similarly to the electrode top height imbalance U1, an electrode bottom height imbalance U3 can be obtained using the following equations.

$$U3 = (Max \text{ (electrode bottom height)} - Min \text{ (electrode bottom height))} / (electrode thickness)$$

$$U3 = (Max \text{ (electrode bottom height)} - Min \text{ (electrode bottom height))} / (electrode tip interval)$$

$$U3 = Max \text{ (electrode bottom height)} / Min \text{ (electrode bottom height)}$$

In the case that the electrode bottom height imbalance U3 is out of the permissible range, similarly to the electrode top height imbalance U1, the suction position of the suction nozzle of the mounter X2 may be corrected in the direction from the location giving the maximum value of the electrode bottom height toward the location giving the minimum value of the electrode bottom height.

(4. Land projection amount imbalance)

In the case that the electronic component is disposed at the correct loading position, terminals or land portions having the identical shape should be identical to each other in a land projection amount. Accordingly, the land projection amount is calculated as the feature amount, and the nonuniformity of the land projection amount can be set to the inspection item.

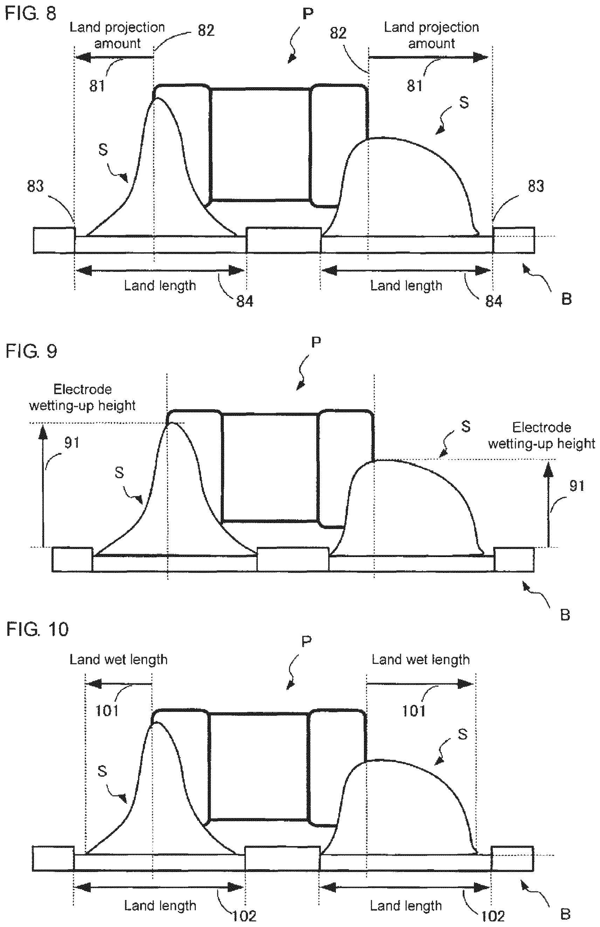

Fig. 8 illustrates the case that the electronic component P of the chip component is soldered while disposed on the printed circuit board B with a deviation from the target position toward a left direction in Fig. 8. Because the electronic component P is disposed with the deviation, a land projection amount 81 varies depending on the location. As used herein, the land projection amount means a land length that does not overlap the electronic component P in the land on the printed circuit board B. In the case that the electronic component P is the lead component, the land length of the portion that overlaps neither the component body nor the lead in the land corresponds to the land projection amount. In order to obtain the land projection amount in a certain location, the nonuniformity calculator 20 obtains an electrode top edge position 82 and a land end position 83 using the result of the appearance inspection or X-ray inspection. The land projection amount 81 is obtained as a distance between the electrode top edge position 82 and the land end position 83.

On the basis of the obtained land projection amount, a land projection amount imbalance U4 can be obtained using the following equation.

$$U4 = Max \text{ (land projection amount)} - Min \text{ (land projection amount)}$$

The land projection amount imbalance U4 may be obtained according to another calculation formula as long as the calculation formula can express the nonuniformity of the land projection amount. For example, using a size (for example, land length 84 in Fig. 8) of the land, the land projection amount imbalance may be normalized as follows.

$$U4 = (Max \text{ (land projection amount)} - Min \text{ (land projection amount))} / (land length)$$

In this case, the land length of the printed circuit board may previously be stored while correlated with the electronic component, or the land length may be calculated from the inspection image.

The ratio between the maximum value and minimum value of the land projection amount may be adopted as the land projection amount imbalance U4.

$$U4 = \text{Max (land projection amount)} / \text{Min (land projection amount)}$$

Additionally, a statistic, such as the variance or standard deviation of the land projection amount in the plural portions, which expresses the variation of the value, may be adopted as the land projection amount imbalance U4.

That the electronic component P is disposed on the board B while deviating from the target position is attributed to the fact that the position (loading position) where the electronic component P is mounted using the suction nozzle varies and deviates from the target position when the mounter X2 mounts the electronic component P on the board B. When the component loading position deviates, the land projection amount is shortened in the deviation direction, and the land projection amount is lengthened in the opposite direction to the deviation direction. Accordingly, preferably the component loading position of the suction nozzle of the mounter X2 is corrected in the direction from the location giving the minimum value of the land projection amount toward the location giving the maximum value of the land projection amount. The mounting condition of the mounter X2, which should be corrected in the case that the nonuniformity of the land projection amount is out of the permissible range, and a mounting condition correcting method are stored in the table 50 (Fig. 4). A fixed value may be adopted as a change amount of the loading position, or the change amount of the loading position may be decided according to the value of the land projection amount imbalance.

(5. Electrode wetting-up height imbalance)

In the case that the electronic component is disposed at the correct loading position, the terminals having the identical shape should be identical to each other in an electrode-side solder wetting-up height. Accordingly, the electrode-side solder wetting-up height is calculated as the feature amount, and the nonuniformity of the electrode-side solder wetting-up height can be set to the inspection item.

Fig. 9 illustrates the case that the electronic component P of the chip component is soldered while disposed on the printed circuit board B with a deviation from the target position toward the left direction in Fig. 9. Because the electronic component P is disposed with the deviation, an amount of solder paste overlapping the electrode varies, and therefore a wetting-up height 91 (electrode wetting-up height) of the solder relative to the electrode also varies. As illustrated in Fig. 9, the electrode wetting-up height increases with increasing amount of solder paste overlapping the electrode.

In order to obtain the electrode wetting-up height in a certain location, the nonuniformity calculator 20 may obtain the edge position of the electrode top using the result of the appearance inspection or X-ray inspection, and obtain the solder height at the edge position.

On the basis of the obtained electrode wetting-up height, an electrode wetting-up height imbalance U5 can be obtained using the following equation.

$$U5 = \text{Max (electrode wetting-up height)} - \text{Min (electrode wetting-up height)}$$

The electrode wetting-up height imbalance U5 may be obtained according to another calculation formula as long as the calculation formula can express the nonuniformity of the electrode wetting-up height. For example, using a size (for example, electrode thickness) of the electronic component, the electrode wetting-up height imbalance may be normalized as follows.

$$U5 = (\text{Max (electrode wetting-up height)} - \text{Min (electrode wetting-up height)}) / (\text{electrode thickness})$$

In this case, the electrode thickness of the electronic component may previously be stored while correlated with the electronic component, or the electrode thickness may be calculated from the inspection image.

The ratio between the maximum value and minimum value of the electrode wetting-up height may be adopted as the electrode wetting-up height imbalance U5.

$$U5 = \text{Max (electrode wetting-up height)} / \text{Min (electrode wetting-up height)}$$

Additionally, a statistic, such as the variance or standard deviation of the electrode wetting-up height in the plural portions, which expresses the variation of the value, may be adopted as the electrode wetting-up height imbalance U5.

That the electronic component P is disposed on the board B while deviating from the target position is attributed to the fact that the position (loading position) where the electronic component P is mounted using the suction nozzle varies and deviates from the target position when the mounter X2 mounts the electronic component P on the board B. When the component loading position deviates, the electrode wetting-up height increases in the deviation direction, and the electrode wetting-up height decreases in the opposite direction to the deviation direction. Accordingly, preferably the component loading position of the suction nozzle of the mounter X2 is corrected in the direction from the location giving the maximum value of the electrode wetting-up height toward the location giving the minimum value of the electrode wetting-up height. The mounting condition of the mounter X2, which should be corrected in the case that the nonuniformity of the electrode wetting-up height is out of the permissible range, and a mounting condition correcting method are stored in the table 50 (Fig. 4). A fixed value may be adopted as a change amount of the loading position, or the change amount of the loading position may be decided according to the value of electrode wetting-up height imbalance U5.

(6. Land wet length imbalance)

In the case that the electronic component is disposed at the correct loading position, the terminals or land portions having the identical shape should be identical to each other in a wet length of the solder on the land. Accordingly, the wet length on the land is calculated as the feature amount, and the nonuniformity of the wet length can be set to the inspection item.

Fig. 10 illustrates the case that the electronic component P of the chip component is soldered while disposed on the printed circuit board B with a deviation from the target position toward the left direction in Fig. 10. Because the electronic component P is disposed with the deviation, a land-side solder wet length 101 (land wet length) varies depending on the location. In order to obtain the land wet length in a certain location, the nonuniformity calculator 20 obtains the edge position of the electrode top and the solder end position on the land using the result of the appearance inspection or X-ray inspection. The land wet length is obtained from the difference between the edge position of the electrode top and the solder end position on the land.

On the basis of the obtained land wet length, a land wet length imbalance U6 can be obtained using the following equation.

$$U6 = \text{Max (land wet length)} - \text{Min (land wet length)}$$

The land wet length imbalance U6 may be obtained according to another calculation formula as long as the calculation formula can express the nonuniformity of the land wet length. For example, using a size (for example, land length 102 in Fig. 10) of the land, the land wet length imbalance may be normalized as follows.

$$U6 = (\text{Max (land wet length)} - \text{Min (land wet length)}) / (\text{land length})$$

In this case, the land length of the printed circuit board may previously be stored while correlated with the electronic component, or the land length may be calculated from the inspection image.

The ratio between the maximum value and minimum value of the land wet length may be adopted as the land wet length imbalance U6.

$$U6 = \text{Max (land wet length)} / \text{Min (land wet length)}$$

Additionally, a statistic, such as the variance or standard deviation of the land wet length in the plural portions, which expresses the variation of the value, may be adopted as the land wet length imbalance U6.

That the electronic component P is disposed on the board B while deviating from the target position is attributed to the fact that the position (loading position) where the electronic component P is mounted using the suction nozzle varies and deviates from the target position when the mounter X2 mounts the electronic component P on the board B. When the component loading position deviates, the land wet length is shortened in the deviation direction, and the land wet length is lengthened in the opposite direction to the deviation direction. Accordingly, preferably the component loading position of the suction nozzle of the mounter X2 is corrected in the direction from the location giving the minimum value of the land wet length toward the location giving the maximum value of the land wet length. The mounting condition of the mounter X2, which should be corrected in the case that the nonuniformity of the land wet length is out of the permissible range, and a mounting condition correcting method are stored in the table 50 (Fig. 4). A fixed value may be adopted as a change amount of the loading position, or the change amount of the loading position may be decided according to the value of the land wet length imbalance U6.

(7. Land wet angle imbalance)

In the case that the electronic component is disposed at the correct loading position, the terminals or land portions having the identical shape should be identical to each other in a wet angle of the solder on the land. Accordingly, the wet angle on the land is calculated as the feature amount, and the nonuniformity of the wet angle can be set to the inspection item.

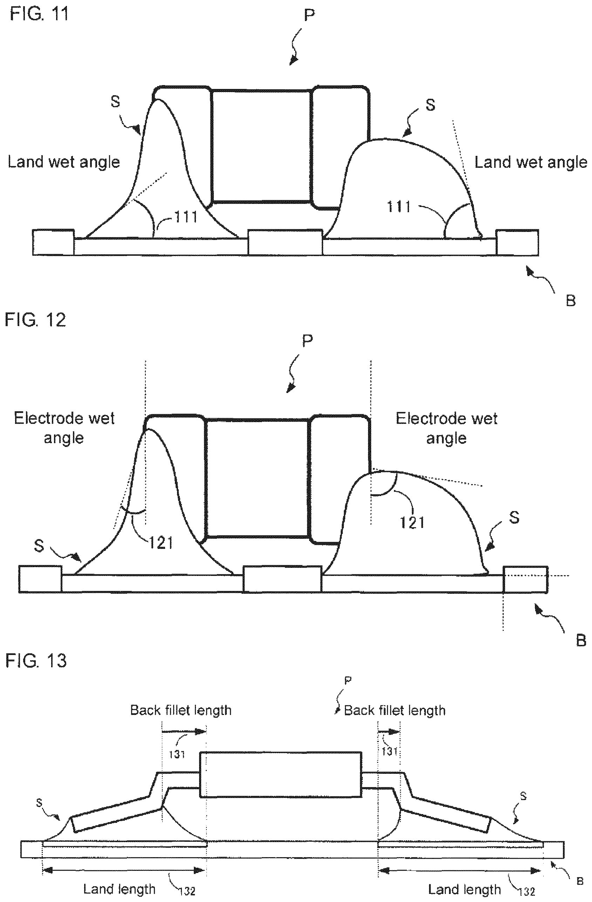

Fig. 11 illustrates the case that the electronic component P of the chip component is soldered while disposed on the printed circuit board B with a deviation from the target position toward the left direction in Fig. 11. Because the electronic component P is disposed with the deviation, a land-side solder wet angle 111 (land wet angle) varies depending on the location. In order to obtain the land wet angle in a certain location, the nonuniformity calculator 20 obtains a height distribution (gradient) near the solder end position on the land using the result of the appearance inspection or X-ray inspection.

On the basis of the obtained land wet angle, a land wet angle imbalance U7 can be obtained using the following equation.

$$U7 = \text{Max (land wet angle)} - \text{Min (land wet angle)}$$

The land wet angle imbalance U7 may be obtained according to another calculation formula as long as the calculation formula can express the nonuniformity of the land wet angle. The ratio between the maximum value and minimum value of the land wet angle may be adopted as the land wet angle imbalance U7.

$$U7 = \text{Max (land wet angle)} / \text{Min (land wet angle)}$$

Additionally, a statistic, such as the variance or standard deviation of the land wet angle in the plural portions, which expresses the variation of the value, may be adopted as the land wet angle imbalance U7.

That the electronic component P is disposed on the board B while deviating from the target position is attributed to the fact that the position (loading position) where the electronic component P is mounted using the suction nozzle varies and deviates from the target position when the mounter X2 mounts the electronic component P on the board B. When the component loading position deviates, the land wet angle decreases in the deviation direction, and the land wet angle increases in the opposite direction to the deviation direction. Accordingly, preferably the component loading position of the suction nozzle of the mounter X2 is corrected in the direction from the location giving the minimum value of the land wet angle toward the location giving the maximum value of the land wet angle. The mounting condition of the mounter X2, which should be corrected in the case that the nonuniformity of the land wet angle is out of the permissible range, and a mounting condition correcting method are stored in the table 50 (Fig. 4). A fixed value may be adopted as a change amount of the loading position, or the change amount of the loading position may be decided according to the value of the land wet angle imbalance U7.

(8. Electrode wet angle imbalance)

In the case that the electronic component is disposed at the correct loading position, the terminals or land portions having the identical shape should be identical to each other in an electrode-side solder wet angle. Accordingly, the wet angle on the electrode is calculated as the feature amount, and the nonuniformity of the wet angle can be set to the inspection item.

Fig. 12 illustrates the case that the electronic component P of the chip component is soldered while disposed on the printed circuit board B with a deviation from the target position toward the left direction in Fig. 12. Because the electronic component P is disposed with the deviation, an electrode-side solder wet angle 111 (electrode wet angle) varies depending on the location. In order to obtain the electrode wet angle in a certain location, the nonuniformity calculator 20 may obtain a height distribution (gradient) near the solder end position bonded to the electrode using the result of the appearance inspection or X-ray inspection,

On the basis of the obtained electrode wet angle, an electrode wet angle imbalance U8 can be obtained using

the following equation.

$$U8 = \text{Max (electrode wet angle)} - \text{Min (electrode wet angle)}$$

The electrode wet angle imbalance U8 may be obtained according to another calculation formula as long as the calculation formula can express the nonuniformity of the electrode wet angle. The ratio between the maximum value and minimum value of the electrode wet angle may be adopted as the electrode wet angle imbalance U8.

$$U8 = \text{Max (electrode wet angle)} / \text{Min (electrode wet angle)}$$

Additionally, a statistic, such as the variance or standard deviation of the electrode wet angle in the plural portions, which expresses the variation of the value, may be adopted as the electrode wet angle imbalance U8.

That the electronic component P is disposed on the board B while deviating from the target position is attributed to the fact that the position (loading position) where the electronic component P is mounted using the suction nozzle varies and deviates from the target position when the mounter X2 mounts the electronic component P on the board B. When the component loading position deviates, the electrode wet angle decreases in the deviation direction, and the electrode wet angle increases in the opposite direction to the deviation direction. Accordingly, preferably the component loading position of the suction nozzle of the mounter X2 is corrected in the direction from the location giving the minimum value of the electrode wet angle toward the location giving the maximum value of the electrode wet angle. The mounting condition of the mounter X2, which should be corrected in the case that the nonuniformity of the electrode wet angle is out of the permissible range, and a mounting condition correcting method are stored in the table 50 (Fig. 4). A fixed value may be adopted as a change amount of the loading position, or the change amount of the loading position may be decided according to the value of the electrode wet angle imbalance U8.

(9. Back fillet length imbalance)

In the case that the electronic component is disposed at the correct loading position, terminals or land portions having the identical shape should be identical to each other in a back fillet length. Accordingly, the back fillet length is calculated as the feature amount, and the nonuniformity of the back fillet length can be set to the inspection item.

Fig. 13 illustrates the case that the electronic component P of the lead component is soldered while disposed on the printed circuit board B with a deviation from the target position toward the left direction in Fig. 13. Because the electronic component P is disposed with the deviation, a fillet length 131 (back fillet length) on a lower side of the electrode varies depending on the location. In order to obtain the back fillet length in a certain location, the nonuniformity calculator 20 obtains an edge position on the land side of the back fillet and an edge position on the electrode side from the X-ray image, and obtains the difference between the edge position on the land side of the back fillet and the edge position on the electrode side.

On the basis of the obtained back fillet length, a back fillet length imbalance U9 can be obtained using the following equation.

$$U9 = \text{Max (back fillet length)} - \text{Min (back fillet length)}$$

The back fillet length imbalance U9 may be obtained according to another calculation formula as long as the calculation formula can express the nonuniformity of the back fillet length. For example, using a size (for example, land length 132 in Fig. 13) of the land, the back fillet length imbalance may be normalized as follows.

$$U9 = (\text{Max (back fillet length)} - \text{Min (back fillet length)}) / (\text{land length})$$

In this case, the land length of the printed circuit board may previously be stored while correlated with the electronic component, or the land length may be calculated from the inspection image.

The ratio between the maximum value and minimum value of the back fillet length may be adopted as the back fillet length imbalance U9.

$$U9 = Max \text{ (back fillet length)} / Min \text{ (back fillet length)}$$

Additionally, a statistic, such as the variance or standard deviation of the back fillet length in the plural portions, which expresses the variation of the value, may be adopted as the back fillet length imbalance U9.

That the electronic component P is disposed on the board B while deviating from the target position is attributed to the fact that the position (loading position) where the electronic component P is mounted using the suction nozzle varies and deviates from the target position when the mounter X2 mounts the electronic component P on the board B. When the component loading position deviates, the back fillet length is lengthened in the deviation direction, and the back fillet length is shortened in the opposite direction to the deviation direction. Accordingly, preferably the component loading position of the suction nozzle of the mounter X2 is corrected in the direction from the location giving the maximum value of the back fillet length toward the location giving the minimum value of the back fillet length. The mounting condition of the mounter X2, which should be corrected in the case that the nonuniformity of the back fillet length is out of the permissible range, and a mounting condition correcting method are stored in the table 50 (Fig. 4). A fixed value may be adopted as a change amount of the loading position, or the change amount of the loading position may be decided according to the value of the back fillet length imbalance U9.

<Advantageous effect of first embodiment>

In the first embodiment, the defect predictor caused by the mounter (mounting apparatus) is detected on the basis of the solder shape obtained by the post-reflow appearance inspection or X-ray inspection, and the setting parameter of the mounter can be corrected before the generation of the defect. Accordingly, the generation of the defect can be prevented before it happens. The situation in which the production line is stopped in order to adjust the setting parameter can be minimized.

Because the nonuniformity (imbalance) described in the first embodiment is the inspection item that needs not to be determined to be defective, the nonuniformity is not the measurement target in the conventional quality inspection system. On the other hand, in the first embodiment, the nonuniformity is comprehended as the defect predictor, and the mounter setting parameter that becomes the generation factor and the setting parameter correcting method are previously stored, which allows the mounter setting parameter to be corrected at a stage of the defect predictor.

(Second embodiment)

In the first embodiment, the solder shape is measured from the post-reflow mounting board, the defect predictor of the mounter X2 is detected on the basis of the measurement result, and the setting parameter (mounting condition) of the mounter X2 is changed. In a second embodiment, the defect predictor of the solder printing apparatus X1 is detected from the solder shape on the post-reflow mounting board, and the setting parameter (printing condition) of the solder printing apparatus X1 is changed.

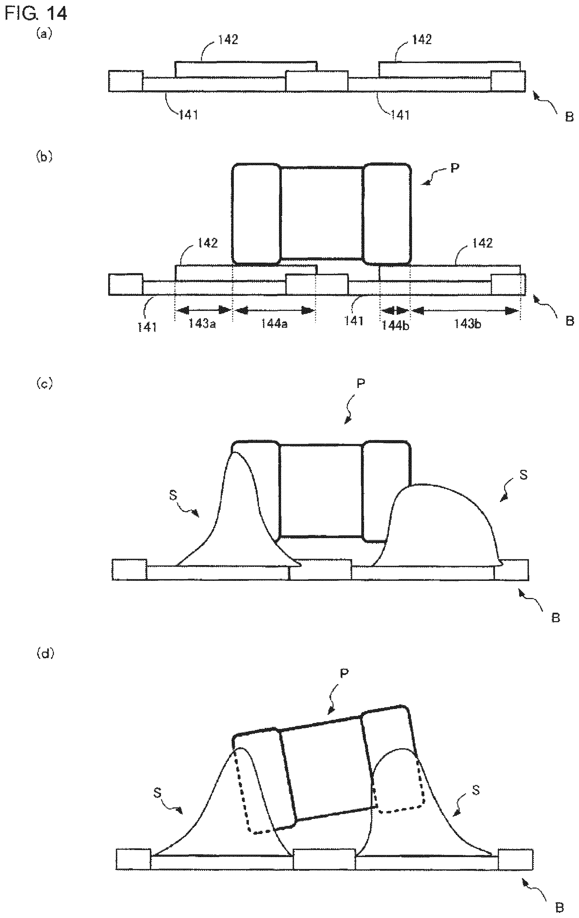

First, post-reflow nonuniformity caused by printing misalignment in the solder printing process will be described below. It is assumed that the printing misalignment of the solder relative to the board B is generated as illustrated in Fig. 14(a). In Fig. 14(a), a solder paste 142 that should originally be printed on the basis of the position of a land 141 is printed while deviating in the right direction. The printing misalignment is generated by the deviation between the mask position and the board position. When the component P is placed at the correct position relative to the board in the mount process as illustrated in Fig. 14(b), solder amounts (volume) 143a and 143b located outside end faces of the electrode differ from each other, which results in a difference of the post-reflow solder shape. As illustrated in Fig. 14(b), the solder amount increases on the electrode side in the direction in which the solder printing position deviates.

As illustrated in Fig. 14(c), the land wet angle and the electrode wet angle increase on the side, which has the larger solder amount located outside the end face of the electrode. The electrode wetting-up height decreases because a wet area expands. Accordingly, when a mask setting position, namely, the solder printing position (the parameter is a mask offset) is shifted toward the direction in which the land wet angle decreases, the electrode wet angle decreases, and the electrode wetting-up height increases, the solder printing position can be put into a proper state.

Contact areas 144a and 144b between the electrode bottom and the solder vary due to the printing misalignment. In the electrode having the wider contact area of the solder, as illustrated in Fig, 14(d), sometimes the component floats by stronger withdrawal of the solder compared with the electrode having the narrower contact area of the solder. That is, the nonuniformity that the height (the electrode top height, the component body edge height, and the electrode bottom height) of the electrode increases is generated on the side on where the solder printing misalignment is generated. Accordingly, when the mask setting position is shifted in the direction in which the electrode top height, the component body edge height, and the electrode bottom height decrease, the solder printing position can be put into the proper state.

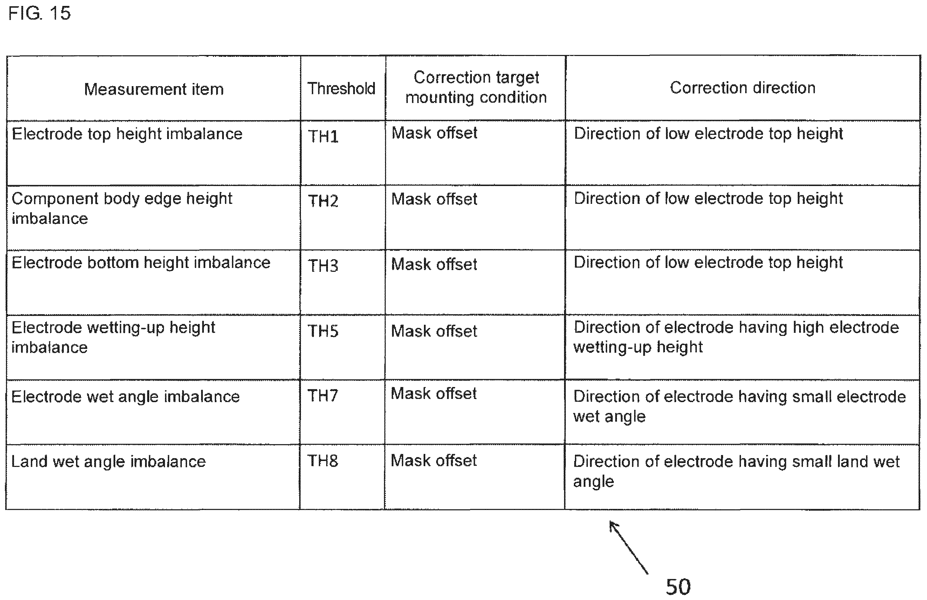

In the quality control system of the second embodiment, on the basis of the above knowledge, the parameter of the solder printing process is changed in consideration of the imbalance of the post-reflow solder shape. The functional blocks of the quality control system of the second embodiment are basically similar to those of the first embodiment (Fig. 2), and are different from those of the first embodiment in the inspection item and the setting parameter to be corrected. Fig. 15 illustrates an example of the table 50 of the second embodiment. The table 50 is a table in which the threshold expressing the permissible range of the nonuniformity, the printing condition that is corrected when the nonuniformity is out of the permissible range, and how to correct the printing condition (mask offset) are stored every inspection item.

Because the electrode top height imbalance, the component body edge height imbalance, the electrode bottom height imbalance, the electrode wetting-up height imbalance, the land wet angle imbalance, and the electrode wet angle imbalance are already described with reference to Figs. 5, 6, 7, 9, 11, and Fig. 12, the descriptions of the imbalances are not repeated.

Even in the second embodiment, as illustrated in the flowchart of Fig. 4, the appearance inspection image or the X-ray inspection image is acquired, and the nonuniformity calculator 20 calculates the nonuniformity with respect to the inspection item. When the calculated nonuniformity is smaller than the threshold stored in the table 50, the nonuniformity is determined to be normal, but particular processing is not performed. When nonuniformity is greater than or equal to the threshold, the instruction is transmitted to the production facility management apparatus X4 such that the printing condition of the solder printing apparatus X1 is changed according to the inspection item by referring to the table 50.

In the second embodiment, the defect predictor caused by the solder printing apparatus is detected on the basis of the solder shape obtained by the post-reflow appearance inspection or X-ray inspection, and the setting parameter of the solder printing apparatus can be corrected before the generation of the defect. Accordingly, the generation of the defect can be prevented before it happens. The situation in which the production line is stopped in order to adjust the setting parameter can be minimized.

<Others>

The descriptions of the above embodiments are only illustrative, and the present invention is not limited to the specific embodiments. Various modifications can be made without departing from the technical idea of the present invention.

In the above embodiments, by way of example, the setting parameters of the component suction position and component loading position of the mounter are changed on the basis of the nonuniformity of the inspection item such as the position and solder shape of the electronic component through the appearance inspection or the X-ray inspection. As to the setting parameter that should be changed in the case that the nonuniformity is out of the permissible range, additionally the setting parameters such as the pushing amount in mounting the component and the loading speed in the mounter may be changed. Alternatively, the setting parameters such as the solder printing position, the solder amount, the printing pressure, and the printing speed in the solder printing apparatus may be changed.

In the above embodiments, the correction directions of the component suction position, component loading position, and printing position are the direction from the location where various feature amounts give the maximum value (minimum value) toward the location giving the minimum value (maximum value). However, the correction direction is not limited to the directions of the above embodiments. For example, the direction (for example, the direction closest to the above correction direction in the plural previously-fixed correction directions) that is decided on the basis of the direction from the location where the feature amount gives the maximum value (minimum value) toward the location where the feature amount gives the minimum value (maximum value) may be adopted. In the case that the average value of the feature amounts is obtained in each group of the line, the direction, which is perpendicular to the line, from the group (line) giving the maximum value (minimum value) toward the group (line) giving the minimum value (maximum value) may be adopted as the correction direction.

In the above embodiments, the setting parameter is automatically changed in the case that the nonuniformity is out of the permissible range. Alternatively, the change of the setting parameter is only proposed to the user, and the user may actually change the parameter. Alternatively, while the change of the setting parameter is proposed to the user, the display asking the user whether the change of the setting parameter is permitted is performed, and the quality control apparatus may change the setting parameter with respect to the production facility management apparatus when the input to permit the change is received from the user. In proposing the change of the setting parameter to the user, preferably the kind of the feature amount (inspection item) having the nonuniformity greater than or equal to the threshold, the nonuniformity of the feature amount, and the setting parameter of the change target are presented to the user. The detailed presentation is suitable for the case that the quality control apparatus automatically changes the setting parameter.

The first and second embodiments can be combined with each other. That is, the setting parameters of the solder printing apparatus and mounter can be changed on the basis of the nonuniformity of the post-reflow solder shape. In the case that a certain imbalance (for example, the electrode top height imbalance) is greater than or equal to the threshold, the setting parameters of both the solder printing apparatus and the mounter may be changed, or the setting parameter of one of the solder printing apparatus and the mounter may be changed. The setting parameter that changes according to the combination of the nonuniformities greater than or equal to the threshold may be decided. For example, only the setting parameters of the mounter may be changed in the case that only one of the electrode top height imbalance and the electrode wet angle imbalance is greater than or equal to the threshold, and the setting parameter of the solder printing apparatus may be changed in the case that both the electrode top height imbalance and the electrode wet angle imbalance are greater than or equal to the threshold.

In the above embodiments, the functions of changing the mounting condition on the basis of the nonuniformity are implemented only by the analyzer Y6. Alternatively, the functions may be shared and implemented by the apparatuses of the quality control system Y. For example, instead that the analyzer Y6 calculates the nonuniformity or the feature amount, the nonuniformity or the feature amount may be calculated by one of or cooperation of the appearance inspection apparatus Y3, the X-ray inspection apparatus Y4, and the inspection management apparatus Y5. Similarly, the determination processing or the instruction to change the mounting condition may be performed by any apparatus. That is, the above functions may be implemented as a whole system, but there is no particular limitation to the specific mode.

DESCRIPTION OF SYMBOLS

X1 solder printing apparatus
X2 mounter
X3 reflow furnace
X4 production facility management apparatus
Y1 solder printing inspection apparatus
Y2 component inspection apparatus
Y3 appearance inspection apparatus
Y4 X-ray inspection apparatus
Y5 inspection management apparatus
Y6 analyzer
Y7 workstation
10 appearance inspection image and X-ray inspection image acquisition part
20 nonuniformity calculator
30 determination part
40 mounting condition changer

**Claims**

1. A quality control apparatus configured to manage a surface mounting line in which a solder printing process, a mount process, and a reflow process are performed, solder being printed onto a printed circuit board with a solder printing apparatus (X1) in the solder printing process, an electronic component being disposed on the printed circuit board with a mounter (X2) in the mount process, the electronic component being soldered with a reflow furnace (X3) in the reflow process, the quality control apparatus comprising:

   a nonuniformity calculating unit (20) configured to calculate nonuniformity being a degree of imbalance of a plurality of feature amounts being measured values of inspection items detected in a post-reflow inspection after said reflow process from a plurality of different portions on the printed circuit board, and to calculate said degree of imbalance based on a difference or a ratio between a maximum value and a minimum value of each of the plurality of feature amounts;
   a determination unit (30) configured to determine whether the degree of imbalance is greater than or equal to a predetermined threshold; and
   a parameter changing unit (40) configured to change a setting parameter of the solder printing apparatus (X1) or the mounter (X2) or to propose the change in setting parameter when said determination unit (30) determines the degree of imbalance to be greater than or equal to the predetermined threshold.

2. The quality control apparatus according to claim 1, wherein the nonuniformity calculating unit (20) is adapted to calculate the degree of imbalance with respect to a plurality of kinds of the feature amounts,
   the determination unit (30) has a different threshold in each kind of the feature amount, and is adapted to make a determination of each kind of the feature amount, and
the parameter changing unit (40) is adapted to decide, when said determination unit (30) determines the degree of imbalance of at least one of the plurality of kinds of the feature amounts to-be greater-than or equal to a predetermined threshold, the setting parameter to be changed according to the kind of the feature amount with the degree of imbalance greater than or equal to the predetermined threshold.

3. The quality control apparatus according to claim 2, wherein the parameter changing unit (40) includes a table in which the kind of the feature amount with the degree of imbalance greater than or equal to the predetermined threshold, the setting parameter to be changed, and a method for changing the setting parameter are correlated with one another.

4. The quality control apparatus according to any one of claims 1 to 3, wherein
the feature amount is a height position of an electrode top of the electronic component,
the setting parameter is a component suction position of the mounter (X2), and
the parameter changing unit (40) is adapted to change the setting parameter or proposes the change of the setting parameter such that the component suction position is moved in a direction toward a portion giving a minimum value of a height of the electrode top.

5. The quality control apparatus according to any one of claims 1 to 3, wherein
the feature amount is a height position of an edge of the electronic component,
the setting parameter is a component suction position of the mounter (X2), and
the parameter changing unit (40) is adapted to change the setting parameter or proposes the change of the setting parameter such that the component suction position is moved in a direction toward a portion giving a minimum value of a height of the edge.

6. The quality control apparatus according to any one of claims 1 to 3, wherein
the feature amount is a height position of an electrode bottom of the electronic component,
the setting parameter is a component suction position of the mounter (X2), and
the parameter changing unit (40) is adapted to change the setting parameter or proposes the change of the setting parameter such that the component suction position is moved in a direction toward a portion giving a minimum value of a height of the electrode bottom.

7. The quality control apparatus according to any one of claims 1 to 3, wherein
the feature amount is a land projection amount which is a land length that does not overlap the electronic component,
the setting parameter is a component loading position of the mounter (X2), and
the parameter changing unit (40) is adapted to change the setting parameter or proposes the change the setting parameter such that the component loading position is moved in a direction toward a portion giving a maximum value of the land projection amount.

8. The quality control apparatus according to any one of claims 1 to 3, wherein
the feature amount is a wetting-up height of the solder relative to an electrode of the electronic component,
the setting parameter is a component loading position of the mounter (X2), and
the parameter changing unit (40) is adapted to change the setting parameter or proposes the change of the setting parameter such that the component loading position is moved in a direction toward a portion giving a minimum value of the wetting-up height.

9. The quality control apparatus according to any one of claims 1 to 3, wherein
the feature amount is a land wet length which is a solder length that does not overlap the electronic component on a land,
the setting parameter is a component loading position of the mounter (X2), and
the parameter changing unit (40) is adapted to change the setting parameter or proposes the change of the setting parameter such that the component loading position is moved in a direction toward a portion giving a maximum value of the land wet length.

10. The quality control apparatus according to any one of claims 1 to 3, wherein
the feature amount is a wet angle on a land side of solder bonding the electronic component,
the setting parameter is a component loading position of the mounter (X2), and
the parameter changing unit (40) is adapted to change the setting parameter or proposes the change of the setting parameter such that the component loading position is moved in a direction toward a portion giving a maximum value of the wet angle.

11. The quality control apparatus according to any one of claims 1 to 3, wherein
the feature amount is a wet angle on an electrode side of solder bonding the electronic component,
the setting parameter is a component loading position of the mounter (X2), and
the parameter changing unit (40) is adapted to change the setting parameter or proposes the change of the setting parameter such that the component loading position is moved in a direction toward a portion giving a maximum value of the wet angle.

12. The quality control apparatus according to any one of claims 1 to 3, wherein
the feature amount is a length of a back fillet of solder bonding the electronic component,
the setting parameter is a component loading position of the mounter (X2), and
the parameter changing unit (40) is adapted to change the setting parameter or proposes the change of the setting parameter such that the component loading position is moved in a direction toward a portion giving a minimum value of the length of the back fillet.

13. The quality control apparatus according to any one of claims 1 to 12, wherein the parameter changing unit (40) is adapted to present the kind of the feature amounts with the degree of imbalance greater than or equal to the predetermined threshold, the degree of imbalance of the corresponding feature amounts, and the setting parameter of a change target to a user, when changing the setting parameter or when proposing the change of the setting parameter to the user.

14. The quality control apparatus according to any one of claims 1 to 13, wherein the parameter changing unit (40) is adapted to propose the change of the setting parameter to the user and to ask the user whether the change of the setting parameter is permitted, and the parameter changing unit (40) change the setting parameter when receiving an input to permit the change from the user.

15. A quality control method for a quality control apparatus configured to manage a surface mounting line in which a solder printing process, a mount process, and a reflow process are performed, solder being printed onto a printed circuit board with a solder printing apparatus(X1) in the solder printing process, an electronic component being disposed on the printed circuit board with a mounter (X2) in the mount process, the electronic component being soldered with a reflow furnace (X3) in the reflow process,
wherein the method comprises the following steps:

a feature amount calculating step of calculating nonuniformity being a degree of imbalance of a plurality of feature amounts being measured values of inspection items detected in a post-reflow inspection after said reflow process from a plurality of different portions on the printed circuit board, and to calculate said degree of imbalance based on a difference or a ratio between a maximum value and a minimum value of each of the plurality of feature amounts;
a determination step of determining whether the degree of imbalance is greater than or equal to a predetermined threshold; and
a parameter changing step of changing a setting parameter of one of the solder printing apparatus and the mounter or of proposing the change in setting parameter to a user, when the degree of imbalance is greater than or equal to the predetermined threshold.

16. A program configured to cause a computer to perform each step of the method according to claim 15.

**Patentansprüche**

1. Qualitätskontrollvorrichtung, die konfiguriert ist, eine Flächenbestückungslinie zu verwalten, in der ein Lötdruckprozess, ein Bestückungsprozess und ein Reflow-Prozess durchgeführt werden, wobei in dem Lötdruckprozess mit einer Lötdruckvorrichtung (X1) Lot auf eine Leiterplatte gedruckt wird, eine elektronische Komponente in dem Bestückungsprozess mit einer Bestückungsvorrichtung (X2) auf der Leiterplatte angeordnet wird, wobei die elektronische Komponente mit einem Reflow-Ofen (X3) in dem Reflow-Prozess gelötet wird, wobei die Qualitätskontrollvorrichtung umfasst:

eine Ungleichförmigkeitsberechnungseinheit (20), die konfiguriert ist, Ungleichförmigkeit als einen Grad der Ungleichförmigkeit einer Vielzahl von Merkmalbeträgen, die gemessene Werte der Prüfobjekte sind, die in einer Nach-Reflow-Prüfung nach dem Reflow-Prozess aus einer Vielzahl unterschiedlicher Abschnitte auf der Leiterplatte erkannt werden, zu berechnen, und den Grad der Ungleichförmigkeit basierend auf einer Differenz oder einem Verhältnis zwischen einem Maximalwert und einem Minimalwert von jedem der Vielzahl der Merkmalbeträge zu berechnen;

eine Bestimmungseinheit (30), die konfiguriert ist, zu bestimmen, ob der Grad der Ungleichförmigkeit größer oder gleich einem vorbestimmten Schwellenwert ist; und

eine Parameteränderungseinheit (40), die konfiguriert ist, einen Einstellungsparameter der Lötdruckvorrichtung (X1) oder der Bestückungsvorrichtung (X2) zu ändern oder die Änderung im Einstellungsparameter vorzuschlagen, wenn die Bestimmungseinheit (30) bestimmt, dass der Grad der Ungleichförmigkeit größer oder gleich dem vorbestimmten Schwellenwert ist.

2. Qualitätskontrollvorrichtung nach Anspruch 1, wobei die Ungleichförmigkeitsberechnungseinheit (20) ausgelegt ist, den Grad der Ungleichförmigkeit in Bezug auf eine Vielzahl von Arten der Merkmalbeträge zu berechnen, die Bestimmungseinheit (30) einen unterschiedlichen Schwellenwert in jeder Art des Merkmalbetrags aufweist und ausgelegt ist, eine Bestimmung jeder Art des Merkmalbetrags zu machen, und die Parameteränderungseinheit (40) ausgelegt ist, wenn die Bestimmungseinheit (30) bestimmt, dass der Grad der Ungleichförmigkeit von mindestens einer der Vielzahl von Arten des Merkmalbetrags größer oder gleich einem vorbestimmten Schwellenwert ist, den Einstellungsparameter zu entscheiden, der gemäß der Art des Merkmalbetrags zu ändern ist, wobei der Grad der Ungleichförmigkeit größer oder gleich dem vorbestimmten Schwellenwert ist.

3. Qualitätskontrollvorrichtung nach Anspruch 2, wobei die Parameteränderungseinheit (40) eine Tabelle beinhaltet, in der die Art des Merkmalbetrags mit dem Grad der Ungleichförmigkeit größer oder gleich dem vorbestimmten Schwellenwert, der zu ändernde Parameter und ein Verfahren zum Ändern des Einstellungsparameters miteinander korreliert sind.

4. Qualitätskontrollvorrichtung nach einem der Ansprüche 1 bis 3, wobei der Merkmalbetrag eine Höhenposition einer Elektrodenspitze der elektronischen Komponente ist, der Einstellungsparameter eine Komponentenansaugposition der Bestückungsvorrichtung (X2) ist, und die Parameteränderungseinheit (40) ausgelegt ist, den Einstellungsparameter derart zu ändern oder die Änderung des Einstellungsparameters derart vorzuschlagen, dass die Komponentenansaugposition in eine Richtung in Richtung eines Abschnitts bewegt wird, der einen Mindestwert einer Höhe der Elektrodenspitze gibt.

5. Qualitätskontrollvorrichtung nach einem der Ansprüche 1 bis 3, wobei der Merkmalbetrag eine Höhenposition einer Kante der elektronischen Komponente ist, der Einstellungsparameter eine Komponentenansaugposition der Bestückungsvorrichtung (X2) ist, und die Parameteränderungseinheit (40) ausgelegt ist, den Einstellungsparameter derart zu ändern oder die Änderung des Einstellungsparameters derart vorzuschlagen, dass die Komponentenansaugposition in eine Richtung in Richtung eines Abschnitts bewegt wird, der einen Mindestwert einer Höhe der Kante gibt.

6. Qualitätskontrollvorrichtung nach einem der Ansprüche 1 bis 3, wobei der Merkmalbetrag eine Höhenposition eines Elektrodenbodens der elektronischen Komponente ist, der Einstellungsparameter eine Komponentenansaugposition der Bestückungsvorrichtung (X2) ist, und die Parameteränderungseinheit (40) ausgelegt ist, den Einstellungsparameter derart zu ändern oder die Änderung des Einstellungsparameters derart vorzuschlagen, dass die Komponentenansaugposition in eine Richtung in Richtung eines Abschnitts bewegt wird, der einen Mindestwert einer Höhe des Elektrodenbodens gibt.

7. Qualitätskontrollvorrichtung nach einem der Ansprüche 1 bis 3, wobei der Merkmalbetrag ein Landprojektionsbetrag ist, der eine Landlänge ist, die die elektronische Komponente nicht überlappt, der Einstellungsparameter eine Komponentenladeposition der Bestückungsvorrichtung (X2) ist, und die Parameteränderungseinheit (40) ausgelegt ist, den Einstellungsparameter derart zu ändern oder die Änderung des Einstellungsparameters derart vorzuschlagen, dass die Komponentenladeposition in eine Richtung in Richtung eines Abschnitts bewegt wird, der einen Maximalwert des Landprojektionsbetrags gibt.

8. Qualitätskontrollvorrichtung nach einem der Ansprüche 1 bis 3, wobei der Merkmalbetrag eine Benetzungshöhe des Lots in Bezug auf eine Elektrode der elektronischen Komponente ist,

der Einstellungsparameter eine Komponentenladeposition der Bestückungsvorrichtung (X2) ist, und die Parameteränderungseinheit (40) ausgelegt ist, den Einstellungsparameter derart zu ändern oder die Änderung des Einstellungsparameters derart zu vorzuschlagen, dass die Komponentenladeposition in eine Richtung in Richtung eines Abschnitts bewegt wird, der einen Mindestwert der Benetzungshöhe gibt.

9. Qualitätskontrollvorrichtung nach einem der Ansprüche 1 bis 3, wobei
der Merkmalbetrag eine Landbenetzungslänge ist, die eine Lotlänge ist, die die elektronische Komponente auf einem Land nicht überlappt,
der Einstellungsparameter eine Komponentenladeposition der Bestückungsvorrichtung (X2) ist, und
die Parameteränderungseinheit (40) ausgelegt ist, den Einstellungsparameter derart zu ändern oder die Änderung des Einstellungsparameters derart vorzuschlagen, dass die Komponentenladeposition in eine Richtung in Richtung eines Abschnitts bewegt wird, der einen Maximalwert Landbenetzungslänge gibt.

10. Qualitätskontrollvorrichtung nach einem der Ansprüche 1 bis 3, wobei
der Merkmalbetrag ein Benetzungswinkel auf einer Landseite des Lots ist, das die elektronische Komponente bindet,
der Einstellungsparameter eine Komponentenladeposition der Bestückungsvorrichtung (X2) ist, und
die Parameteränderungseinheit (40) ausgelegt ist, den Einstellungsparameter derart zu ändern oder die Änderung des Einstellungsparameters derart vorzuschlagen, dass die Komponentenladeposition in eine Richtung in Richtung eines Abschnitts bewegt wird, der einen Maximalwert des Benetzungswinkels gibt.

11. Qualitätskontrollvorrichtung nach einem der Ansprüche 1 bis 3, wobei
der Merkmalbetrag ein Benetzungswinkel auf einer Elektrodenseite des Lots ist, das die elektronische Komponente bindet,
der Einstellungsparameter eine Komponentenladeposition der Bestückungsvorrichtung (X2) ist, und
die Parameteränderungseinheit (40) ausgelegt ist, den Einstellungsparameter derart zu ändern oder die Änderung des Einstellungsparameters derart vorzuschlagen, dass die Komponentenladeposition in eine Richtung in Richtung eines Abschnitts bewegt wird, der einen Maximalwert des Benetzungswinkels gibt.

12. Qualitätskontrollvorrichtung nach einem der Ansprüche 1 bis 3, wobei
der Merkmalbetrag eine Länge einer Rückausrundung des Lots ist, das die elektronische Komponente bindet,
der Einstellungsparameter eine Komponentenladeposition der Bestückungsvorrichtung (X2) ist, und
die Parameteränderungseinheit (40) ausgelegt ist, den Einstellungsparameter derart zu ändern oder die Änderung des Einstellungsparameters derart vorzuschlagen, dass die Komponentenladeposition in eine Richtung in Richtung eines Abschnitts bewegt wird, der einen Mindestwert der Länge der Rückausrundung gibt.

13. Qualitätskontrollvorrichtung nach einem der Ansprüche 1 bis 12, wobei die Parameteränderungseinheit (40) ausgelegt ist, die Art der Merkmalbeträge, wobei der Grad der Ungleichförmigkeit größer oder gleich dem vorbestimmten Schwellenwert ist, den Grad der Ungleichförmigkeit der entsprechenden Merkmalbeträge und den Einstellungsparameter eines Änderungsziels einem Benutzer zu präsentieren, wenn der Einstellungsparameter geändert wird oder wenn die Änderung des Einstellungsparameters dem Benutzer vorgeschlagen wird.

14. Qualitätskontrollvorrichtung nach einem der Ansprüche 1 bis 13, wobei die Parameteränderungseinheit (40) ausgelegt ist, die Änderung des Einstellungsparameters dem Benutzer vorzuschlagen, und den Benutzer zu fragen, ob die Änderung des Einstellungsparameters zulässig ist, und die Parameteränderungseinheit (40) den Einstellungsparameter ändert, wenn eine Eingabe zum Zulassen der Änderung von dem Benutzer empfangen wird.

15. Qualitätskontrollverfahren für eine Qualitätskontrollvorrichtung, die konfiguriert ist, eine Flächenbestückungslinie zu verwalten, in der ein Lötdruckprozess, ein Bestückungsprozess und ein Reflow-Prozess durchgeführt werden, wobei in dem Lötdruckprozess mit einer Lötdruckvorrichtung (X1) Lot auf eine Leiterplatte gedruckt wird, eine elektronische Komponente in dem Bestückungsprozess mit einer Bestückungsvorrichtung (X2) auf der Leiterplatte angeordnet wird, wobei die elektronische Komponente mit einem Reflow-Ofen (X3) in dem Reflow-Prozess gelötet wird, wobei das Verfahren die folgenden Schritte umfasst:

einen Merkmalbetragberechnungsschritt des Berechnens von Ungleichförmigkeit als einen Grad der Ungleichförmigkeit einer Vielzahl von Merkmalbeträgen, die gemessene Werte der Prüfobjekte sind, die in einer Nach-Reflow-Prüfung nach dem Reflow-Prozess aus einer Vielzahl unterschiedlicher Abschnitte auf der Leiterplatte erkannt werden, und den Grad der Ungleichförmigkeit basierend auf einer Differenz oder einem Verhältnis zwischen einem Maximalwert und einem Minimalwert von jedem der Vielzahl der Merkmalbeträge zu berechnen;

einen Bestimmungsschritt des Bestimmens, ob der Grad der Ungleichförmigkeit größer oder gleich einem vorbestimmten Schwellenwert ist; und

einen Parameteränderungsschritt des Änderns eines Einstellungsparameters von einem von der Lötdruckvorrichtung oder der Bestückungsvorrichtung oder Vorschlagen der Änderung im Einstellungsparameter an einen Benutzer, wenn der Grad der Ungleichförmigkeit größer oder gleich einem vorbestimmten Schwellenwert ist.

16. Programm, das konfiguriert ist, einen Computer zu veranlassen, jeden Schritt des Verfahrens nach Anspruch 15 durchzuführen.

**Revendications**

1. Appareil de contrôle de qualité configuré de manière à ce qu'il gère une ligne de montage en surface au niveau de laquelle un processus d'impression de soudure, un processus de montage et un processus de refusion sont réalisés, la soudure étant imprimée sur une carte de circuit imprimé à l'aide d'un appareil d'impression de soudure (X1) au niveau du processus d'impression de soudure, un composant électronique étant disposé sur la carte de circuit imprimé à l'aide d'un moyen de montage (X2) au niveau du processus de montage, le composant électronique étant soudé à l'aide d'un four de refusion (X3) au niveau du processus de refusion, l'appareil de contrôle de qualité comprenant :

une unité de calcul de non uniformité (20) qui est configurée de manière à ce qu'elle calcule la non uniformité qui est un degré de déséquilibre d'une pluralité de quantités de caractéristique qui sont des valeurs mesurées d'éléments d'inspection qui sont détectés lors d'une inspection de post-refusion après ledit processus de refusion à partir d'une pluralité de différentes parties sur la carte de circuit imprimé, et de manière à ce qu'elle calcule ledit degré de déséquilibre sur la base d'une différence ou d'un rapport entre une valeur maximum et une valeur minimum de chacune de la pluralité de quantités de caractéristique ;

une unité de détermination (30) qui est configurée de manière à ce qu'elle détermine si oui ou non le degré de déséquilibre est supérieur ou égal à un seuil prédéterminé ; et

une unité de modification de paramètre (40) qui est configurée de manière à ce qu'elle modifie un paramètre de réglage de l'appareil d'impression de soudure (X1) ou du moyen de montage (X2) ou de manière à ce qu'elle propose la modification du paramètre de réglage lorsque ladite unité de détermination (30) détermine que le degré de déséquilibre est supérieur ou égal au seuil prédéterminé.

2. Appareil de contrôle de qualité selon la revendication 1, dans lequel :

l'unité de calcul de non uniformité (20) est adaptée de manière à ce qu'elle calcule le degré de déséquilibre par rapport à une pluralité de types des quantités de caractéristique ;

l'unité de détermination (30) présente un seuil différent pour chaque type de la quantité de caractéristique et est adaptée de manière à ce qu'elle réalise une détermination de chaque type de la quantité de caractéristique ; et

l'unité de modification de paramètre (40) est adaptée de manière à ce qu'elle décide, lorsque ladite unité de détermination (30) détermine que le degré de déséquilibre d'au moins l'un de la pluralité de types des quantités de caractéristique est supérieur ou égal à un seuil prédéterminé, quel paramètre de réglage doit être modifié en fonction du type de la quantité de caractéristique qui présente le degré de déséquilibre supérieur ou égal au seuil prédéterminé.

3. Appareil de contrôle de qualité selon la revendication 2, dans lequel l'unité de modification de paramètre (40) inclut une table à l'intérieur de laquelle le type de la quantité de caractéristique qui présente le degré de déséquilibre supérieur ou égal au seuil prédéterminé, le paramètre de réglage qui doit être modifié et un procédé pour modifier le paramètre de réglage sont corrélés les uns aux autres.

4. Appareil de contrôle de qualité selon l'une quelconque des revendications 1 à 3, dans lequel :

la quantité de caractéristique est une position en hauteur d'un sommet d'électrode du composant électronique ;
le paramètre de réglage est une position d'aspiration de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position d'aspiration de composant soit déplacée dans une direction vers une partie qui assure une valeur minimum d'une hauteur du sommet d'électrode.

**5.** Appareil de contrôle de qualité selon l'une quelconque des revendications 1 à 3, dans lequel :

la quantité de caractéristique est une position en hauteur d'un bord du composant électronique ;
le paramètre de réglage est une position d'aspiration de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position d'aspiration de composant soit déplacée dans une direction vers une partie qui assure une valeur minimum d'une hauteur du bord.

**6.** Appareil de contrôle de qualité selon l'une quelconque des revendications 1 à 3, dans lequel :

la quantité de caractéristique est une position en hauteur d'un fond d'électrode du composant électronique ;
le paramètre de réglage est une position d'aspiration de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position d'aspiration de composant soit déplacée dans une direction vers une partie qui assure une valeur minimum d'une hauteur du fond d'électrode.

**7.** Appareil de contrôle de qualité selon l'une quelconque des revendications 1 à 3, dans lequel :

la quantité de caractéristique est une quantité de projection de zone qui est une longueur de zone qui ne chevauche pas le composant électronique ;
le paramètre de réglage est une position de chargement de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position de chargement de composant soit déplacée dans une direction vers une partie qui assure une valeur maximum de la quantité de projection de zone.

**8.** Appareil de contrôle de qualité selon l'une quelconque des revendications 1 à 3, dans lequel :

la quantité de caractéristique est une hauteur de mouillage de la soudure par rapport à une électrode du composant électronique ;
le paramètre de réglage est une position de chargement de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position de chargement de composant soit déplacée dans une direction vers une partie qui assure une valeur minimum de la hauteur de mouillage.

**9.** Appareil de contrôle de qualité selon l'une quelconque des revendications 1 à 3, dans lequel :

la quantité de caractéristique est une longueur de zone mouillée qui est une longueur de soudure qui ne chevauche pas le composant électronique sur une zone ;
le paramètre de réglage est une position de chargement de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position de chargement de composant soit déplacée dans une direction vers une partie qui assure une valeur maximum de la longueur de zone mouillée.

**10.** Appareil de contrôle de qualité selon l'une quelconque des revendications 1 à 3, dans lequel :

la quantité de caractéristique est un angle de mouillage sur un côté de zone d'une soudure qui assure la liaison du composant électronique ;
le paramètre de réglage est une position de chargement de composant du moyen de montage (X2) ; et
l'unité de modification de paramètre (40) est adaptée de manière à ce qu'elle modifie le paramètre de réglage ou de manière à ce qu'elle propose la modification du paramètre de réglage de telle sorte que la position de chargement de composant soit déplacée dans une direction vers une partie qui assure une valeur maximum de l'angle de mouillage.

**11.** Appareil de contrôle de qualité selon l'une quelconque des revendications 1 à 3, dans lequel :

la quantité de caractéristique est un angle de mouillage sur un côté d'électrode d'une soudure qui assure la liaison du composant électronique ;

le paramètre de réglage est une position de chargement de composant du moyen de montage (X2) ; et

l'unité de modification de paramètre (40) est adaptée de manière à ce qu'elle modifie le paramètre de réglage ou de manière à ce qu'elle propose la modification du paramètre de réglage de telle sorte que la position de chargement de composant soit déplacée dans une direction vers une partie qui assure une valeur maximum de l'angle de mouillage.

**12.** Appareil de contrôle de qualité selon l'une quelconque des revendications 1 à 3, dans lequel :

la quantité de caractéristique est une longueur d'un filet arrière d'une soudure qui assure la liaison du composant électronique ;

le paramètre de réglage est une position de chargement de composant du moyen de montage (X2) ; et

l'unité de modification de paramètre (40) est adaptée de manière à ce qu'elle modifie le paramètre de réglage ou de manière à ce qu'elle propose la modification du paramètre de réglage de telle sorte que la position de chargement de composant soit déplacée dans une direction vers une partie qui assure une valeur minimum de la longueur du filet arrière.

**13.** Appareil de contrôle de qualité selon l'une quelconque des revendications 1 à 12, dans lequel l'unité de modification de paramètre (40) est adaptée de manière à ce qu'elle présente le type des quantités de caractéristique qui présente le degré de déséquilibre supérieur ou égal au seuil prédéterminé, le degré de déséquilibre des quantités de caractéristique correspondantes et le paramètre de réglage d'une cible de modification à un utilisateur, lors de la modification du paramètre de réglage ou lors de la proposition de la modification du paramètre de réglage à l'utilisateur.

**14.** Appareil de contrôle de qualité selon l'une quelconque des revendications 1 à 13, dans lequel l'unité de modification de paramètre (40) est adaptée de manière à ce qu'elle propose la modification du paramètre de réglage à l'utilisateur et de manière à ce qu'elle demande à l'utilisateur si oui ou non la modification du paramètre de réglage est autorisée, et l'unité de modification de paramètre (40) modifie le paramètre de réglage lors de la réception d'une entrée en provenance de l'utilisateur pour permettre la modification.

**15.** Procédé de contrôle de qualité pour un appareil de contrôle de qualité qui est configuré de manière à ce qu'il gère une ligne de montage en surface au niveau de laquelle un processus d'impression de soudure, un processus de montage et un processus de refusion sont réalisés, la soudure étant imprimée sur une carte de circuit imprimé à l'aide d'un appareil d'impression de soudure (X1) au niveau du processus d'impression de soudure, un composant électronique étant disposé sur la carte de circuit imprimé à l'aide d'un moyen de montage (X2) au niveau du processus de montage, le composant électronique étant soudé à l'aide d'un four de refusion (X3) au niveau du processus de refusion, dans lequel le procédé comprend les étapes qui suivent :

une étape de calcul de quantité de caractéristique qui consiste à calculer la non uniformité qui est un degré de déséquilibre d'une pluralité de quantités de caractéristique qui sont des valeurs mesurées d'éléments d'inspection qui sont détectés lors d'une inspection de post-refusion après ledit processus de refusion à partir d'une pluralité de différentes parties sur la carte de circuit imprimé, et qui consiste à calculer ledit degré de déséquilibre sur la base d'une différence ou d'un rapport entre une valeur maximum et une valeur minimum de chacune de la pluralité de quantités de caractéristique ;

une étape de détermination qui consiste à déterminer si oui ou non le degré de déséquilibre est supérieur ou égal à un seuil prédéterminé ; et

une étape de modification de paramètre qui consiste à modifier un paramètre de réglage d'un appareil pris parmi l'appareil d'impression de soudure et le moyen de montage ou qui consiste à proposer la modification du paramètre de réglage à un utilisateur, lorsque le degré de déséquilibre est supérieur ou égal au seuil prédéterminé.

**16.** Programme configuré de manière à ce qu'il force un ordinateur à réaliser chaque étape du procédé selon la revendication 15.

FIG. 1

FIG. 2

```
┌─────────────────────────────┐
│ Appearance inspection image │── 10
│ and X-ray inspection image  │
│      acquisition part       │
└─────────────────────────────┘
              │
              ▼
┌─────────────────────────────┐
│                             │── 20
│   Nonuniformity calculator  │
│                             │
└─────────────────────────────┘
              │
              ▼
┌─────────────────────────────┐      ── 30
│                             │◄──────────────┐
│     Determination part      │               │
│                             │               │
└─────────────────────────────┘               │
              │                                │
              ▼                    ── 40       │
┌─────────────────────────────┐               │
│                             │◄──────────────┤
│ Mounting condition changer  │               │
└─────────────────────────────┘               │
```

```
        ╭───────────────╮  ── 50
        │               │
        │ Nonuniformity and
        │ mounting condition
        │  correspondence
        │      table
        ╰───────────────╯
```

FIG. 3

| Measurement item | Threshold | Correction target mounting condition | Correction direction |
|---|---|---|---|
| Electrode top height imbalance | TH1 | Component suction position | Direction of low electrode top height |
| Component body edge height imbalance | TH2 | Component suction position | Direction of low electrode top height |
| Electrode bottom height imbalance | TH3 | Component suction position | Direction of low electrode top height |
| Land projection amount imbalance | TH4 | Component loading position | Direction of electrode having large land projection amount |
| Electrode wetting-up height imbalance | TH5 | Component loading position | Direction of electrode having low electrode wetting-up height |
| Land wet length imbalance | TH6 | Component loading position | Direction of electrode having large land wet length |
| Electrode wet angle imbalance | TH7 | Component loading position | Direction of electrode having large electrode wet angle |
| Land wet angle imbalance | TH8 | Component loading position | Direction of electrode having large land wet angle |
| Back fillet length | TH9 | Component loading position | Tip direction of electrode having short back fillet |

50

EP 3 096 596 B1

FIG. 4

```
                    ┌─────────────┐
                    │    START    │
                    └──────┬──────┘
                           │
                           ▼
        ┌──────────────────────────────────────┐  S1
        │ Acquire appearance inspection image and│
        │        X-ray inspection image          │
        └──────────────────┬───────────────────┘
                           │
                           ▼
        ┌──────────────────────────────────────┐
        │       Loop in each inspection item     │
        └──────────────────┬───────────────────┘
                           │
                           ▼
        ┌──────────────────────────────────────┐  S2
        │         Calculate nonuniformity        │
        └──────────────────┬───────────────────┘
                           │
                           ▼
                        ◇ S3                      NO
              Nonuniformity
          is greater than or equal to ──────────────┐
                 threshold?                          │
                   │ YES                             │
                   ▼                                 │
        ┌──────────────────────────────────────┐ S4 │
        │   Issue instruction to change mounting │   │
        │        condition of mounter            │   │
        └──────────────────┬───────────────────┘   │
                           │◄───────────────────────┘
                           ▼
        ┌──────────────────────────────────────┐
        │                                        │
        └──────────────────┬───────────────────┘
                           │
                           ▼
                    ┌─────────────┐
                    │     END     │
                    └─────────────┘
```

FIG. 5

FIG. 6

FIG. 7

FIG. 8

Land projection amount

82

P

82

Land projection amount

81

S

81

S

83

83

Land length

84

Land length

84

B

FIG. 9

P

Electrode wetting-up height

91

S

S

Electrode wetting-up height

91

B

FIG. 10

P

Land wet length

101

S

Land wet length

101

S

S

Land length

102

Land length

102

B

FIG. 11

FIG. 12

FIG. 13

FIG. 14

(a)

(b)

(c)

(d)

FIG. 15

| Measurement item | Threshold | Correction target mounting condition | Correction direction |
|---|---|---|---|
| Electrode top height imbalance | TH1 | Mask offset | Direction of low electrode top height |
| Component body edge height imbalance | TH2 | Mask offset | Direction of low electrode top height |
| Electrode bottom height imbalance | TH3 | Mask offset | Direction of low electrode top height |
| Electrode wetting-up height imbalance | TH5 | Mask offset | Direction of electrode having high electrode wetting-up height |
| Electrode wet angle imbalance | TH7 | Mask offset | Direction of electrode having small electrode wet angle |
| Land wet angle imbalance | TH8 | Mask offset | Direction of electrode having small land wet angle |

50

EP 3 096 596 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007043009 A
- US 2008166039 A1
- US 5560533 A